# EUROPÄISCHE PATENTSCHRIFT

(11) **EP 2 124 515 B1**
(45) Veröffentlichungstag und Bekanntmachung des Hinweises auf die Patenterteilung: **01.02.2012**
(21) Anmeldenummer: 09006441.1
(22) Anmeldetag: 13.05.2009
(51) Int. Cl.: H05K 3/10, H05K 3/24

(54) **Verfahren zur Herstellung einer elektrisch leitenden Schichtstruktur**
Method for manufacturing of a conductive coating structure
Procédé de fabrication d'une structure de couche électrique conductrice

(30) Priorität: 20.05.2008 DE 102008024451
(43) Veröffentlichungstag der Anmeldung: 25.11.2009
(73) Patentinhaber: Leonhard Kurz Stiftung & Co. KG, 90763 Fürth (DE)
(72) Erfinder: Rohm, Michael, 90768 Fürth (DE); Attner, Juri, Dr., 90559 Burgthann (DE)
(74) Vertreter: Zinsinger, Norbert

(56) Entgegenhaltungen:
- EP-A- 1 562 412
- GB-A- 2 066 583
- US-A- 4 358 349
- US-A- 5 468 345
- US-A1- 2006 081 476
- US-B1- 6 224 722

## Beschreibung

Die Erfindung betrifft ein Verfahren zur Herstellung mindestens einer musterförmig ausgebildeten, elektrisch leitenden Schichtstruktur auf einem elektrisch isolierenden Substrat, sowie eine danach hergestellte elektrisch leitende Schichtstruktur.

US 6 224 722 B1 beschreibt ein galvanisches Verfahren, bei dem ein bandförmiges isolierendes Substrat um eine rotierende Trommel geführt wird, die teilweise in eine halbzylinderförmige Wanne mit einer elektrolytischen Lösung eintaucht. Eine Seite des Substrats ist mit einer dünnen Metallschicht beschichtet, von der eine darüber aufgebrachte Resistschicht einen sich kontinuierlich über die Länge des Substratbands erstreckenden Streifen sowie damit verbundene Musterbereiche freilässt. An der Innenseite der Wanne sind gruppenweise elektrisch verbundene Anoden so angebracht, dass zwischen dem auf der Außenseite der Trommel geführten Substrat und den Anoden ein Spalt verbleibt. Das aus dem galvanischen Bad auslaufende Substrat wird über eine als Kathode fungierende Umlenkrolle geführt. Dabei ist das Substrat so orientiert, dass seine unbeschichtete Seite an der Außenseite der Trommel anliegt, die beschichtete Seite den Anoden gegenüberliegt, und der kontinuierliche Streifen an der Kathodenrolle anliegt und sich somit in elektrischem Kontakt mit ihr befindet. Weil sich während des Durchlaufs des Substrats durch das Bad die Dicke der abgeschiedenen Metallschicht ständig erhöht und dadurch die Stromleitfähigkeit des Bands kontinuierlich wächst, sind benachbarte Anodengruppen so geschaltet, dass an einer nachfolgenden Gruppe eine höhere Spannung anliegt als an einer vorhergehenden. Es werden also entsprechend der wachsenden Metallschichtdicke schrittweise wachsende Stromstärken eingesetzt, was zu höheren Abscheidungsraten und damit kürzeren Produktionszeiten führt.

Ein Verfahren zur Herstellung einer musterförmig ausgebildeten, elektrisch leitenden Schichtstruktur ist auch aus EP 1 562 412 A2 bekannt. In einem kontinuierlichen Prozess wird hierbei ein elektrisch isolierendes Substrat in Form eines Folienbandes von Rolle zu Rolle transportiert. Auf dem Folienband werden mittels Aufdruckens eines elektrisch leitenden Druckmediums elektrisch leitende Musterbereiche gebildet, welche die gewünschte Form der herzustellenden elektrisch leitenden Schichtstrukturen aufweisen. Das derart präparierte Folienband wird durch galvanische Bäder transportiert und die elektrisch leitenden Musterbereiche galvanisch mit einer Metallschicht verstärkt. Im galvanischen Bad wird die Folienbahn über eine rotierende Trommel gefördert, die an ihrem Umfang und parallel zur Rotationsachse der Trommel eine Anzahl an voneinander beabstandeten Kathodenstäben aufweist. Dabei müssen die elektrisch leitenden Musterbereiche während des Durchlaufs durch das galvanische Bad in direkten Kontakt zu einem Kathodenstab und gleichzeitig in direkten Kontakt zum galvanischen Bad gelangen, um elektrisch kontaktiert zu werden und eine Metallanlagerung in den Musterbereichen zu erzielen.

Aufgrund der vorhandenen Abstände zwischen den Kathodenstäben ist es erforderlich, dass die elektrisch leitenden Musterbereiche in Transportrichtung des Folienbandes eine Mindestabmessung aufweisen, die gewährleistet, dass der elektrisch leitende Musterbereich während des Baddurchlaufs zwangsläufig in elektrisch leitenden Kontakt mit einem Kathodenstab sowie in Kontakt mit dem galvanischen Bad gelangt, damit ein Abscheideprozess im elektrisch leitenden Musterbereich stattfindet. Die Mindestabmessung für einen elektrisch leitenden Musterbereich liegt dabei derzeit bei > 20 mm in Transportrichtung des Folienbandes gesehen.

Die immer weiter fortschreitenden Bemühungen zur Miniaturisierung von elektrischen Bauteilen und Schaltungen stoßen mit dem bisher verfügbaren Verfahren an eine Grenze, da hiermit elektrisch leitende Schichtstrukturen mit einer Abmessung - in Transportrichtung des Folienbandes gesehen - von kleiner als 20 mm nicht zuverlässig auf einem elektrisch isolierenden Substrat ausgebildet werden können. Bei derart kleinen zu beschichtenden Musterbereichen verhindert entweder ein fehlender elektrischer Kontakt zu einem Kathodenstab oder eine komplette Bedeckung des zu beschichtenden Musterbereichs mit dem Kathodenstab unter Verdrängung der Badzusammensetzung eine Metallabscheidung im Musterbereich.

Es ist daher die Aufgabe der Erfindung, einerseits ein Verfahren bereitzustellen, mit welchem sich auch musterförmige elektrisch leitende Schichtstrukturen mit Abmessungen von deutlich kleiner als 20 mm auf einem elektrisch isolierenden Substrat herstellen lassen, und andererseits danach hergestellte elektrisch leitende Schichtstrukturen mit kleineren Abmessungen als bisher möglich bereitzustellen.

Die Aufgabe wird für das Verfahren zur Herstellung mindestens einer musterförmig ausgebildeten, elektrisch leitenden Schichtstruktur auf einem elektrisch isolierenden Substrat durch folgende Schritte gelöst:
Aufbringen einer elektrisch leitenden Schicht auf mindestens einer Oberfläche des Substrats;
Ausbilden einer elektrisch isolierenden Resistschicht in einem ersten Bereich der elektrisch leitenden Schicht, wobei mindestens ein zweiter Bereich der elektrisch leitenden Schicht in Form der zu bildenden mindestens einen musterförmigen Schichtstruktur freigelassen wird und weiterhin mindestens ein streifenförmiger dritter Bereich der elektrisch leitenden Schicht freigelassen wird, wobei die ersten, zweiten und dritten Bereiche der elektrisch leitenden Schicht elektrisch leitend miteinander verbunden sind und der mindestens eine dritte Bereich Enden aufweist, die in Längsrichtung des mindestens einen dritten Bereichs gesehen den mindestens einen zweiten Bereich zumindest einseitig überragen;
Herstellen eines direkten Kontakts zwischen einem Kathodenstab und dem mindestens einen streifenförmigen dritten Bereich der elektrisch leitenden Schicht in einem galvanischen Bad, mit Führen des als flexible Folienbahn ausgebildeten Substrats um einen Abschnitt des Umfangs einer um eine Rotationsachse rotierenden Trommel, die sich zumindest teilweise in das galvanische Bad eingetaucht befindet und an deren Umfang im wesentlichen parallel zu der Rotationsachse angeordnete Kathodenstäbe beabstandet voneinander angeordnet sind, wobei die Oberfläche des Substrats, auf der die elektrisch leitende Schicht aufgebracht ist, zu der Trommel hin orientiert ist;
Galvanisches Abscheiden einer Metallschicht in dem mindestens einen zweiten Bereich und dem mindestens einen dritten Bereich der elektrisch leitenden Schicht; Entfernen der Resistschicht;
Ausbilden der mindestens einen musterförmigen Schichtstruktur, indem die elektrisch leitende Schicht im ersten Bereich und weiterhin die Metallschicht jeweils auf ihrer dem Substrat abgewandten Seite solange durch Ätzen abgetragen werden, bis die elektrisch leitende Schicht im ersten Bereich entfernt ist.

Unter einem streifenförmigen Bereich wird dabei ein Bereich verstanden, der langgestreckt ausgebildet ist und somit länger als breit ist.

Bei dem erfindungsgemäßen Verfahren wird ausgehend von einer vollflächig oder lediglich bereichsweise, insbesondere musterförmig, auf das Substrat aufgebrachten elektrisch leitenden Schicht gestartet. Bei einer vollflächigen Ausbildung der elektrisch leitenden Schicht sind auch noch so kleine zweite Bereiche, in denen die elektrisch leitende Schicht galvanisch zu einer elektrisch leitenden Schichtstruktur aufgebaut werden soll, elektrisch gut leitend mit den in den streifenförmigen dritten Bereichen freiliegenden Abschnitten der elektrisch leitenden Schicht verbunden. Bei einer lediglich bereichsweisen, insbesondere in Form der zu bildenden elektrisch leitenden Schichtstruktur musterförmigen, Ausbildung der elektrisch leitenden Schicht werden die zweiten und dritten Bereiche der elektrisch leitenden Schicht elektrisch leitend miteinander verbunden ausgebildet, vorzugsweise über Hilfsleiterbahnen, die ebenfalls Bestandteil der elektrisch leitenden Schicht sind.

Aufgrund der Ausbildung des mindestens einen zweiten Bereichs in elektrisch leitender Verbindung mit dem mindestens einen streifenförmigen dritten Bereich und dessen Ausgestaltung ist es immer möglich, die elektrisch leitende Schicht mittels eines Kathodenstabs, in dem mindestens einen dritten Bereich elektrisch zu kontaktieren und eine galvanische Abscheidung von Metall in dem damit elektrisch leitend verbundenen mindestens einen zweiten Bereich zu erzielen.

Dabei wird der mindestens eine zweite Bereich und auch der frei liegende mindestens eine dritte Bereich der elektrisch leitenden Schicht galvanisch beschichtet, während in dem mit der elektrisch isolierenden Resistschicht abgedeckten ersten Bereich der elektrisch leitenden Schicht keine galvanische Abscheidung erfolgt. Dies spart Material und ermöglicht ein einfaches Heraustrennen der einzelnen Schichtstrukturen aus einer vollflächigen elektrisch leitenden Schicht auf dem Substrat oder ein Trennen der einzelnen gebildeten Schichtstrukturen der bereichsweise ausgebildeten elektrisch leitfähigen Schicht auf dem Substrat von den übrigen Bereichen der elektrisch leitenden Schicht.

Eine elektrisch leitende Schichtstruktur, gebildet nach dem erfindungsgemäßen Verfahren, kann in der Schichtebene in allen Richtungen Abmessungen von kleiner als 20 mm, besonders bevorzugt von kleiner als 10 mm, insbesondere bevorzugt von kleiner als 1 mm, aufweisen.

Selbstverständlich ist das erfindungsgemäße Verfahren aber auch zur Bildung größer dimensionierter Schichtstrukturen, die beispielsweise eine Länge von > 70 mm aufweisen, verwendbar.

Derart kleine elektrisch leitende Schichtstrukturen konnten bislang nur durch erheblich teurere Verfahren, wie das Drucken von Leitpasten in ausreichender Dicke oder stromloses Plattieren, auf einem elektrisch isolierenden Substrat aufgebaut werden.

Der mindestens eine streifenförmige dritte Bereich kann auf dem Substrat mit einem geraden, schrägen, stufigen, schlangenlinienförmigen oder gekrümmten Verlauf ausgebildet sein. Dabei wird die Ausgestaltung des mindestens einen streifenförmigen dritten Bereichs insbesondere an die Anordnung der zu bildenden Schichtstrukturen auf dem Substrat angepasst.

Es hat sich bewährt, wenn mindestens zwei streifenförmige dritte Bereiche ausgebildet werden. Dies ermöglicht eine optimale Ausnutzung der zur Verfügung stehenden Substratoberfläche zur Bildung der Schichtstrukturen. Auch drei oder mehr streifenförmige dritte Bereiche können vorhanden sein.

Dabei werden die mindestens zwei streifenförmigen dritten Bereiche vorzugsweise parallel zueinander angeordnet, aber auch eine andere Anordnung zueinander ist möglich. So können sich dritte Bereiche überkreuzen, in einem Winkel zueinander verlaufen und/oder in einem Winkel zu einer Längskante des Substrats verlaufen und dergleichen.

Vorzugsweise wird der mindestens eine streifenförmige dritte Bereiche mit einer Streifenlänge von mindestens 20 mm ausgebildet. Dies ermöglicht, unabhängig von einer Anordnung des mindestens einen dritten Bereichs, zuverlässig die elektrische Kontaktierung der elektrisch leitenden Schicht mittels eines Kathodenstabs im mindestens einen dritten Bereich.

Es hat sich bewährt, wenn der mindestens eine streifenförmige dritte Bereich angrenzend an eine Kante, insbesondere an eine Längskante, des Substrats ausgebildet wird. Eine derartige Anordnung ermöglicht eine gleichmäßige elektrische Kontaktierung der elektrisch leitenden Schicht im Bereich der gesamten Oberfläche des Substrats.

Es ist aber genauso möglich, dass der mindestens eine streifenförmige dritte Bereich beabstandet von einer Kante, insbesondere einer Längskante, des Substrats ausgebildet wird. Dies kann insbesondere dann von Vorteil sein, wenn eine gleichmäßige und ununterbrochene Ausbildung der elektrisch leitenden Schicht im Kantenbereich des Substrats, beispielsweise aufgrund von vorhandenen Rauhigkeiten oder ähnlichem, nicht erreicht werden kann. Eine Anordnung eines dritten Bereichs in der Mitte des Substrats hat sich bewährt.

Vorzugsweise wird der mindestens eine streifenförmige dritte Bereich derart ausgebildet, dass dieser sich über eine Länge des Substrats erstreckt. Bei langgestreckten Substraten erstreckt sich vorzugsweise jeweils ein dritter Bereich entlang je einer der Längskanten des Substrats oder ein einzelner dritter Bereich in der Mitte zwischen den beiden Längskanten. Dadurch kann mittels der Kathodenstäbe überall eine elektrische Kontaktierung des mindestens einen dritten Bereichs und somit auch des mindestens einen zweiten Bereichs der elektrisch leitenden Schicht hergestellt werden.

Um eine möglichst gleichmäßige Metallplattierung der elektrisch leitenden Schicht in dem mindestens einen zweiten Bereich zu erzielen, hat es sich als vorteilhaft erwiesen, wenn pro 5 cm bis 20 cm, insbesondere 10 cm, Breite des Substrats jeweils ein streifenförmiger dritter Bereich angeordnet wird, der mittels eines Kathodenstabs elektrisch kontaktiert wird. Je nach Layout der zweiten Bereiche werden dritte Bereiche bevorzugt in Lücken zwischen zweiten Bereichen angeordnet.

Genauso ist es aber möglich, dass der mindestens eine streifenförmige dritte Bereich derart ausgebildet wird, dass dieser sich lediglich über einen Abschnitt des Substrats erstreckt. Bei zwei oder mehr dritten Bereichen gibt es unterschiedliche Arten der Anordnung dieser zueinander.

So können eine Vielzahl von dritten Bereichen in Längsrichtung des Substrats nacheinander folgend angeordnet werden. Die nacheinander angeordneten dritten Bereiche werden dabei beispielsweise von einem ersten Bereich mit der Resistschicht unterbrochen. Eine derartige Anordnung ist insbesondere dann von Vorteil, wenn der mindestens eine zweite Bereich örtlich begrenzt vorliegt oder mehrere zweite Bereiche auf gleicher Höhe nahe nebeneinander, beispielsweise in einer Zeile, vorliegen, wobei aber der Abstand von einem zweiten Bereich zu einem in Längsrichtung des Substrats benachbarten zweiten Bereich, oder beispielsweise von einer Zeile zu einer benachbarten Zeile, relativ groß ist. Auf gleiche Höhe bedeutet hier quer zur Längsrichtung des Substrats. Entsprechend ist eine Zeile von zweiten Bereichen eine Anordnung der zweiten Bereiche quer zur Längsrichtung des Substrats.

Weiterhin können mindestens zwei streifenförmige dritte Bereiche derart ausgebildet werden, dass sie gleiche oder unterschiedliche Längen aufweisen. Dabei hat es sich bewährt, die Enden der mindestens zwei streifenförmigen dritten Bereiche jeweils auf gleicher Höhe oder versetzt zueinander, d.h. in Längsrichtung des Substrats an unterschiedlichen Stellen, anzuordnen.

Unabhängig von der Länge eines dritten Bereichs hat es sich zudem bewährt, wenn der mindestens eine streifenförmige dritte Bereich derart ausgebildet wird, dass dieser mindestens eine Breite b von 1,0 mm aufweist. Vorzugsweise weisen mehrere streifenförmige dritte Bereiche gleiche Breiten b auf, jedoch können auch unterschiedliche Breiten b z.B. hinsichtlich der elektrischen Kontaktierung von Vorteil sein. Es ist möglich, dass mindestens zwei streifenförmige dritte Bereiche gebildet werden, die mit einer unterschiedlichen Breite b ausgebildet werden.

Eine derartige Breite b ist bei einer lediglich bereichsweise auf dem Substrat ausgebildeten elektrisch leitenden Schicht auch hinsichtlich der Hilfsleiterbahnen bevorzugt, welche den mindestens einen zweiten Bereich elektrisch leitend mit dem mindestens einen dritten Bereich verbinden.

Besonders bevorzugt wird im erfindungsgemäßen Verfahren ein langgestrecktes flexibles Substrat eingesetzt, damit ein kontinuierlicher Verfahrensablauf möglich wird. Dabei wird das langgestreckte flexible, d.h. biegsame Substrat während des Verfahrens bevorzugt von Rolle zu Rolle transportiert.

Dazu wird das Substrat auf eine Rolle aufgewickelt bereitgestellt, von dieser abgezogen und unmittelbar einer Einheit zum Auftrag der elektrisch leitenden Schicht zugeführt. Anschließend wird das Substrat mindestens einer Einheit zur Ausbildung der musterförmigen Resistschicht im ersten Bereich auf der elektrisch leitenden Schicht, einer Galvanisiereinheit zur galvanischen Verstärkung der freiliegenden zweiten und dritten Bereiche der elektrisch leitenden Schicht, einer Einheit zum Ablösen der Resistschicht, einer Einheit zum Ätzen der elektrisch leitenden Schicht und der Metallschicht, sowie optional weiteren Reinigungseinheiten, Trocknungs- und/oder Tempereinheiten, Einheiten zum Vereinzeln von mehreren auf dem Substrat gebildeten elektrisch leitenden Schichtstrukturen, oder Einheiten zu deren Weiterverarbeitung, zugeführt.

Besonders bevorzugt ist der Einsatz eines elektrisch isolierenden Substrats in Form einer Folienbahn, insbesondere einer Folienbahn mit einer Foliendicke im Bereich von 12 µm bis 200 µm.

Es hat sich bewährt, wenn die Folienbahn mindestens eine Lage aus Kunststoff, insbesondere aus PET, PET-G, PEN, PE, PC, PVC oder ABS umfasst. Dabei eignen sich insbesondere reine Kunststofffolien oder auch Laminate einer ersten Kunststofflage mit mindestens einer weiteren Lage aus einem dazu unterschiedlichen elektrisch isolierenden Material, insbesondere aus Kunststoff und/oder anorganischen Schichten.

Die elektrisch leitende Schicht wird auf die Oberfläche des elektrisch isolierenden Substrats vorzugsweise durch Aufdampfen, Sputtern, chemische Dampfphasenabscheidung, Prägen oder Laminieren aufgebracht. Um die Haftung der elektrisch leitenden Schicht am Substrat zu verbessern, können dabei auch Haftvermittler- und/oder Kleberschichten zwischen dem Substrat und der elektrisch leitenden Schicht angeordnet werden.

Beim Aufbringen der elektrisch leitenden Schicht mittels Prägens (Heiß- oder Kaltprägen) oder Laminierens werden Präge- oder Laminierfolien umfassend die elektrisch leitende Schicht eingesetzt, wobei als Haftvermittlerschicht zwischen der elektrisch leitenden Schicht und dem Substrat üblicherweise eine Kleberschicht vorgesehen wird. Bei dieser Kleberschicht kann es sich um einen Heißkleber, einen Kaltkleber oder einen unter Bestrahlung, insbesondere UV- oder IR-Bestrahlung, aushärtenden Kleber handeln. Die Kleberschicht kann entweder auf dem Substrat angeordnet sein oder ein Bestandteil der Präge- oder Laminierfolie sein.

Prägefolien weisen im Allgemeinen eine Trägerfolie und eine davon ablösbare, aus dünnen Schichten aufgebaute, üblicherweise nicht selbsttragende Übertragungslage auf, die auf das Substrat übertragen wird. Eine für die Verwendung im erfindungsgemäßen Verfahren geeignete Prägefolie umfasst ausgehend von der Trägerfolie bevorzugt eine optionale Ablöseschicht, die elektrisch leitende Schicht und optional eine Kleberschicht. Anschließend an das Prägen, bei dem die elektrisch leitende Schicht mit dem Substrat verklebt wird, wird die Trägerfolie von der Übertragungslage abgezogen. Lediglich die Übertragungslage oder Bereiche der Übertragungslage verbleibt/verbleiben auf dem Substrat.

Laminierfolien weisen im Allgemeinen eine Trägerfolie und davon nicht ablösbare weitere dünne Schichten auf. Sie werden als ganzes auf das Substrat übertragen. Eine für die Verwendung im erfindungsgemäßen Verfahren geeignete Laminierfolie umfasst auf einer Seite der Trägerfolie die elektrisch leitende Schicht und auf der anderen Seite der Trägerfolie optional eine Kleberschicht. Beim Laminieren wird die Laminierfolie mit dem Substrat verklebt oder unter Wärme- und Druckeinwirkung verbunden.

Um eine möglichst hohe Ausnutzung des Substrats zu erzielen, hat es sich bewährt, wenn mindestens zwei musterförmige Schichtstrukturen auf dem Substrat ausgebildet werden. Diese können auf dem Substrat in regelmäßiger oder unregelmäßiger Anordnung vorliegen. Dabei ist eine regelmäßige Anordnung insbesondere dann von Vorteil, wenn hauptsächlich gleich oder ähnlich geformte Schichtstrukturen oder solche mit ähnlichen Abmessungen auf dem Substrat ausgebildet werden sollen.
Eine Anordnung in Form von Zeilen und/oder Spalten hat sich hierbei bewährt. Dabei werden die Spalten vorzugsweise parallel zu einer Kante, insbesondere einer Längskante, des Substrats angeordnet.

Eine unregelmäßige bzw. beliebige Anordnung ist aber genauso möglich und hat sich insbesondere bewährt, wenn Schichtstrukturen mit sehr unterschiedlichen Formen und/oder Abmessungen auf dem Substrat gebildet werden sollen.

Es ist möglich, dass der mindestens eine zweite Bereich, senkrecht zur Ebene der elektrisch leitenden Schicht gesehen, zumindest bereichsweise in Form von mindestens einer langgestreckten Leiterbahn ausgebildet wird.

Es ist möglich, dass die elektrisch leitende Schicht mit einer Schichtdicke im Bereich von 10 nm bis 10 µm ausgebildet wird. Die elektrisch leitende Schicht wird auf dem Substrat bevorzugt in einer Schichtdicke im Bereich von 100 nm bis 5 µm, insbesondere von 500 nm bis 1,5 µm, ausgebildet.

Vorzugsweise wird die elektrisch leitende Schicht aus einem metallischen und/oder elektrisch leitenden organischen Material gebildet. Vorzugsweise wird die elektrisch leitende Schicht aus Kupfer, Aluminium, Zinn, Silber, Gold, Nickel, Chrom, Kobalt oder Legierungen dieser Metalle gebildet.

Dabei können zur Bildung der elektrisch leitfähigen Schicht und der darauf galvanisch abgeschiedenen Metallschicht gleiche oder unterschiedliche Materialien zum Einsatz kommen.

Ebenso könnte die elektrisch leitende Schicht in den ersten und dritten Bereichen aus einem anderen elektrisch leitenden Material gebildet sein als in den zweiten Bereichen. Im Hinblick auf die Verfahrensökonomie ist es jedoch bevorzugt, wenn die elektrisch leitende Schicht in den ersten, zweiten und dritten Bereichen aus dem gleichen elektrisch leitenden Material gebildet ist.

Es ist möglich, dass die galvanisch abgeschiedene Metallschicht aus dem gleichen oder einem anderen Material gebildet wird wie die elektrisch leitende Schicht.

Es hat sich bewährt, wenn eine Schichtdicke der galvanisch abgeschiedenen Metallschicht dicker ausgebildet wird als eine Schichtdicke der elektrisch leitenden Schicht. Es hat sich insbesondere bewährt, dass eine Schichtdicke der Metallschicht um mindestens 5 % dicker ausgebildet wird als eine Schichtdicke der elektrisch leitenden Schicht, auf welcher die Metallschicht gebildet wird. Dies gewährleistet, dass beim Ätzen die elektrisch leitende Schicht in den ersten Bereichen zuverlässig entfernt werden kann, die galvanisch abgeschiedene Metallschicht in den zweiten und dritten Bereichen jedoch in jedem Fall in ausreichender Schichtdicke auf dem Substrat verbleibt. Dies gilt insbesondere dann, wenn gleiche Materialien zur Bildung der elektrisch leitenden Schicht und der Metallschicht eingesetzt werden, die Metallschicht sich in der verwendeten Ätzlösung schneller auflöst als die elektrisch leitende Schicht, usw.

Es hat sich als günstig erwiesen, wenn die galvanisch abgeschiedene Metallschicht aus Kupfer, Nickel, Kobalt, Chrom, Silber oder Gold gebildet wird.

Eine elektrisch leitende Schicht aus Kupfer in Kombination mit einer Metallschicht aus Kupfer hat sich bewährt. Aber auch andere Materialkombinationen sind möglich.

Die elektrisch isolierende Resistschicht wird vorzugsweise aus thermisch oder unter Bestrahlung, insbesondere UV-Bestrahlung, härtenden Zusammensetzungen gebildet, welche insbesondere unter der Bezeichnung Ein-Komponenten-Ätzresiste oder Galvanoresiste frei erhältlich sind. Die Resistschicht wird vorzugsweise in einer Schichtdicke im Bereich von 100 nm bis 20 µm gebildet. Je dicker dabei die Resistschicht ausgebildet wird, desto breiter ist die Breite b der streifenförmigen dritten Bereiche generell zu wählen, um im galvanischen Bad einen elektrischen Kontakt zwischen dem mindestens einen dritten Bereich der elektrisch leitenden Schicht und einem oder mehreren der Kathodenstäbe zu gewährleisten.
Eine Resistschicht von etwa 20 µm Schichtdicke ist hier bereits problemlos in Kombination mit einem streifenförmigen dritten Bereich mit einer Breite von 1,0 mm einsetzbar.

Ein Verhältnis der Schichtdicke der Resistschicht zu der Breite eines streifenförmigen dritten Bereichs von mindestens 1:50, insbesondere von 1:100, hat sich bewährt.

Vorzugsweise wird die Resistschicht musterförmig auf das Substrat aufgedruckt oder aufgeprägt. Beim Prägen kommt hier insbesondere eine Heißprägefolie zum Einsatz.

Es ist aber genauso möglich, dass die Resistschicht, beispielsweise in Form einer negativen oder positiven Photoresistschicht, vollflächig auf das Substrat aufgebracht und anschließend strukturiert wird, indem sie in dem mindestens einen zweiten Bereich und dem mindestens einen streifenförmigen dritten Bereich entfernt wird. Die Strukturierung kann dabei photolithographisch oder mittels eines Lasers erfolgen.

Eine gebildete elektrisch leitende Schichtstruktur kann jede beliebige Form aufweisen. Vorzugsweise ist die Schichtstruktur in Form einer Elektroden- oder Anschlussfläche, einer Leiterbahn, insbesondere einer mäander- oder spiralförmigen Leiterbahn oder gitterförmig angeordneten Leiterbahn ausgebildet, wie beispielsweise als eine Antennenstruktur, eine Elektrodenstruktur, usw.

Das Verfahren umfasst den folgenden Schritt: Herstellen eines direkten Kontakts zwischen einem Kathodenstab und dem mindestens einen streifenförmigen dritten Bereich der elektrisch leitenden Schicht in einem galvanischen Bad. Der Kathodenstab ist eine Kathode eines zur galvanischen Metallabscheidung geeigneten galvanischen Elements. Der direkte Kontakt kann hergestellt werden, indem eine Oberfläche des dritten Bereichs und eine Oberfläche der Kathode miteinander in Kontakt gebracht werden. Der direkte Kontakt ist dann in ausreichender Weise hergestellt, wenn zwischen dem dritten Bereich und der Kathode ein direkter elektrischer Kontakt vorliegt, d.h. elektrischer Strom fließen kann.

Das Herstellen des direkten Kontakts zwischen dem Kathodenstab und dem mindestens einen streifenförmigen dritter Bereich der elektrisch leitenden Schicht in dem galvanischen Bad umfasst den folgenden Schritt: Führen des als flexible Folienbahn ausgebildeten Substrats um einen Abschnitt des Umfangs einer um eine Rotationsachse rotierenden Trommel, die sich zumindest teilweise in das galvanische Bad eingetaucht befindet und an deren Umfang im wesentlichen parallel zu der Rotationsachse angeordnete Kathodenstäbe beabstandet voneinander angeordnet sind, wobei die Oberfläche des Substrats, auf der die elektrisch leitende Schichtstruktur ausgebildet werden soll, zu der Trommel hin orientiert ist. Die andere Oberfläche des Substrats, die von der zu bildenden elektrisch leitenden Schichtstruktur abgewandt ist, ist von der Trommel abgewandt. Die Kathodenstäbe bilden die Kathoden des galvanischen Elements. Sie sind im wesentlichen parallel zu der Rotationsachse und damit im wesentlichen senkrecht zu der Transportrichtung der Folienbahn des Substrats angeordnet. Es ist möglich, dass die Anode des galvanischen Elements im Bereich der Rotationsachse der Trommel angeordnet ist. Dabei ist die Umlaufgeschwindigkeit des als flexible Folienbahn ausgebildeten Substrats um den Abschnitt des Umfangs der Trommel so auf die Rotationsgeschwindigkeit der Trommel abgestimmt, dass während des Umlaufs die Folienbahn auf einem Umfang der Trommel aufliegt und der mindestens eine streifenförmige dritte Bereich der umlaufenden Folienbahn eine konstante Position relativ zu den auf dem Umfang angeordneten Kathodenstäben einnimmt.

Es ist bevorzugt, dass der mindestens eine dritte Bereich eine in Transportrichtung der Folienbahn gemessene Streifenlänge aufweist, die mindestens so groß wie der entlang des Umfangs gemessene Abstand zwischen benachbarten Kathodenstäben ist. Der entlang des Umfangs gemessene Abstand zwischen zwei benachbarten Kathodenstäben ist definiert als die kleinste Distanz zweier Punkte auf der gestreckten Folienbahn, die beim Umlauf der Folienbahn um die Trommel jeweils an einem der zwei benachbarten Kathodenstäbe anliegen.

In der Praxis ist der entlang des Umfangs gemessene Abstand zwischen zwei benachbarten Kathodenstäben im Bereich von mindestens 20 mm. Der Durchmesser eines typischen Kathodenstabs liegt im Bereich von etwa 5 mm bis etwa 50 mm.

Es ist möglich, dass bei einem lediglich bereichsweisen, insbesondere in Form der zu bildenden elektrisch leitenden Schichtstruktur musterförmigen, Aufbringen der elektrisch leitenden Schicht der erste Bereich der elektrisch leitenden Schicht, in dem die elektrisch isolierende Resistschicht ausgebildet wird, der oder die Bereiche sind, die den mindestens einen zweiten und den mindestens einen dritten Bereich der elektrisch leitenden Schicht elektrisch leitend miteinander verbinden, insbesondere die Hilfsleiterbahnen sind. Dabei wird der mindestens eine zweite Bereich der elektrisch leitenden Schicht in Form der zu bildenden musterförmigen Schichtstrukturen und der mindestens eine streifenförmige dritte Bereich der elektrisch leitenden Schicht von der Resistschicht freigelassen. Das lediglich bereichsweise Aufbringen der elektrisch leitenden Schicht hat gegenüber dem vollflächigen Aufbringen der elektrisch leitenden Schicht den Vorteil des geringeren Materialeinsatzes: es wird weniger zum Aufbringen der elektrisch leitenden Schicht verwendetes Material und weniger zum Ausbilden der Resistschicht verwendetes Material benötigt. Außerdem muss beim Entfernen der Resistschicht weniger Resistmaterial und beim Ätzen weniger Material der elektrisch leitenden Schicht und weniger Material der Metallschicht abgetragen werden.

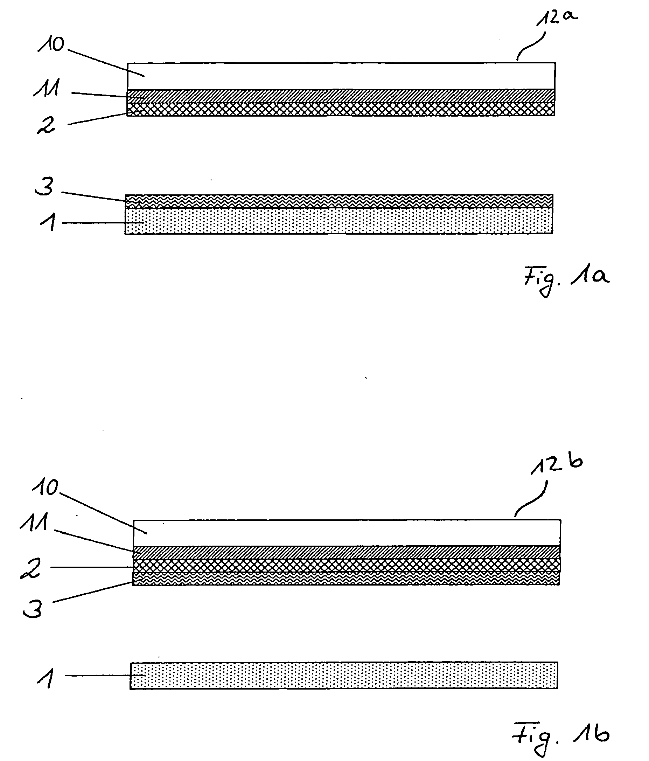

Die Figuren 1a bis 17 sollen das erfindungsgemäße Verfahren zur Herstellung einer musterförmig ausgebildeten, elektrisch leitenden Schichtstruktur auf einem elektrisch isolierenden Substrat beispielhaft erläutern. Die einzelnen Schichten und Schichtbereiche sind dabei zur besseren Übersicht in ihren Größenverhältnissen zueinander nicht wirklichkeitsgetreu dargestellt. So zeigt
- Figur 1a: einen Querschnitt durch eine Prägefolie umfassend eine elektrisch leitende Schicht und weiterhin einen Querschnitt durch ein Substrat;
- Figur 1b: einen weiteren möglichen Querschnitt durch eine Prägefolie umfassend eine elektrisch leitende Schicht und einen Querschnitt durch ein Substrat;
- Figur 2: ein Aufbringen der elektrischen leitenden Schicht auf das Substrat im Querschnitt;
- Figur 3: ein Ablösen der Trägerfolie der Prägefolie vom Substrat im Querschnitt;
- Figur 4a: ein Aufbringen einer musterförmigen Resistschicht im Querschnitt;
- Figur 4b: eine Draufsicht auf die Anordnung gemäß Figur 4a;
- Figur 5a: eine Einheit zum Aufgalvanisieren der zweiten und dritten Bereiche der elektrisch leitenden Schicht mit einer Metallschicht im Querschnitt;
- Figur 5b: das Substrat inklusive der galvanisch gebildeten Metallschicht im Querschnitt;
- Figur 5c: eine Draufsicht auf die Anordnung gemäß Figur 5b;
- Figur 6a: die Anordnung aus den Figuren 5 und 5c nach einem Entfernen der Resistschicht im Querschnitt;
- Figur 6b: eine Draufsicht auf die Anordnung gemäß Figur 6a;
- Figur 7a: die Anordnung aus Figur6a nach einem Entfernen der elektrisch leitenden Schicht im ersten Bereich unter Bildung von musterförmigen elektrisch leitenden Schichtstrukturen;
- Figur 7b: eine Draufsicht auf die Anordnung gemäß Figur 7a;
- Figur 8a: ein Substrat mit einer musterförmig darauf ausgebildeten elektrisch leitenden Schicht im Querschnitt;
- Figur 8b: die Anordnung gemäß Figur 8a in der Draufsicht;
- Figur 9: die Anordnung gemäß Figur 8b nach einem Aufbringen einer musterförmigen Resistschicht in der Draufsicht;
- Figur 10: die Anordnung aus Figur 9 in der Draufsicht nach Aufbringen einer galvanisch gebildeten Metallschicht;
- Figur 11: die Anordnung aus Figur 10 in der Draufsicht nach Entfernung der Resistschicht;
- Figur 12: die Anordnung aus Figur 11 in der Draufsicht nach Entfernen der elektrisch leitenden Schicht im ersten Bereich unter Bildung von musterförmigen elektrisch leitenden Schichtstrukturen:
- Figur 13: ein weiteres Substrat mit einer musterförmigen elektrisch leitenden Schicht in der Draufsicht;
- Figur 14: die Anordnung gemäß Figur 13 nach einem Aufbringen einer musterförmigen Resistschicht;
- Figur 15: die Anordnung gemäß Figur 14 nach einem Aufbringen einer galvanisch abgeschiedenen Metallschicht;
- Figur 16: die Anordnung gemäß Figur 15 nach Entfernen der Resistschicht; und
- Figur 17: die Anordnung gemäß Figur 16 nach einem Ätzen.

Die Figuren 1a und 1b zeigen Verfahrensvarianten, bei welchen die elektrisch leitende Schicht mittels einer Prägefolie vollflächig auf eine Seite des elektrisch isolierenden Substrats aufgebracht wird. Es sind aber auch, wie oben bereits beschrieben, andere Vorgehensweisen zur Bildung der elektrisch leitenden Schicht auf dem Substrat möglich, bei welchen zwischen der elektrischen leitenden Schicht und dem elektrisch isolierenden Substrat keine Kleberschicht benötigt wird, wie z.B. Sputtern, Aufdampfen, usw. Auf die nähere Beschreibung der weiteren möglichen Vorgehensweisen wird hier verzichtet, da diese dem Fachmann geläufig sind.

Figur 1a zeigt einen Querschnitt durch eine Prägefolie 12a, die eine Trägerfolie 10, eine Ablöseschicht 11 und eine elektrisch leitende Schicht 2 aus Kupfer mit einer Schichtdicke von 500 nm umfasst, sowie einen Querschnitt durch ein Substrat 1, dessen Oberfläche von einer elektrisch isolierenden Kleberschicht 3 gebildet ist.

Figur 1b zeigt einen alternativ möglichen Querschnitt durch eine Prägefolie 12b, die eine Trägerfolie 10, eine Ablöseschicht 11, eine elektrisch leitende Schicht 2 aus Kupfer mit einer Schichtdicke von 500 nm und eine elektrisch isolierende Kleberschicht 3 umfasst, sowie einen Querschnitt durch ein Substrat 1.

Die Kleberschicht 3 dient jeweils zur Verklebung des Substrats 1 mit der elektrisch leitenden Schicht 2 und kann im Prinzip als Bestandteil des elektrisch isolierenden Substrats 1 angesehen werden. Die Ablöseschicht 11 der Prägefolien 12a, 12b gemäß den Figuren 1 a und 1 b dient zur Verbesserung des Ablöseverhaltens der elektrisch leitenden Schicht 2 von der Trägerfolie 10 und kann auch weggelassen werden, wenn sich die elektrisch leitende Schicht 2 ohnehin im gewünschten Maß von der Trägerfolie 10 ablösen lässt.

Das Substrat 1 liegt in Form einer flexiblen Folienbahn aus Kunststoff, hier aus PET, mit einer Schichtdicke von 50 µm vor. Das Substrat 1 wird in einem kontinuierlichen Prozess von Rolle zu Rolle verarbeitet, wobei hier und in Folge lediglich jeweils ein Ausschnitt des Substrats 1 dargestellt ist.

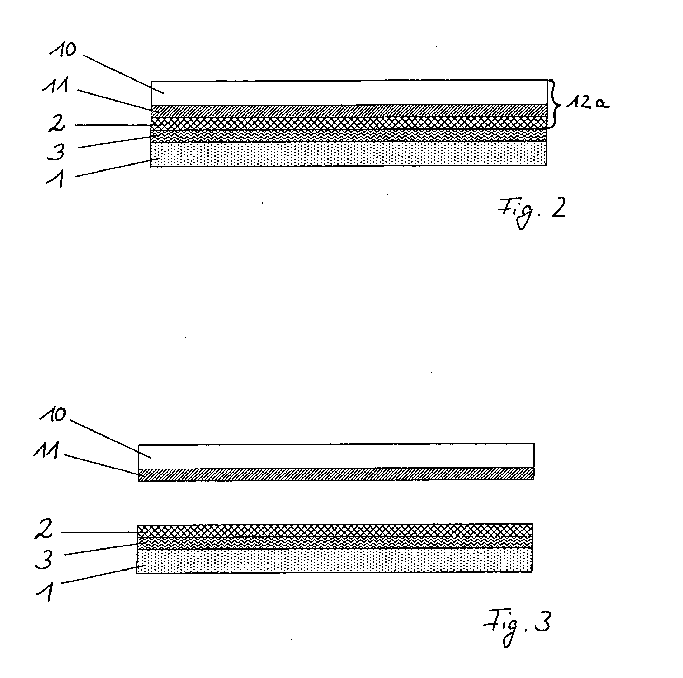

Gemäß Figur 2 wird im Querschnitt gesehen die Prägefolie 12a, oder alternativ die Prägefolie 12b, mit dem Substrat 1 zusammengeführt und die elektrisch leitende Schicht 2 mittels der Kleberschicht 3 auf dem Substrat 1 fixiert. Dies erfolgt in Abstimmung zu der verwendeten Art der Kleberschicht 3. Ist die Kleberschicht 3 aus einem Heißkleber gebildet, erfolgt die Verklebung unter Druck- und Temperaturerhöhung. Ist die Kleberschicht 3 aus einem unter UV-Strahlung vernetzbaren Kleber gebildet, muss entweder das Substrat 1 oder die Trägerfolie 10, gegebenenfalls inklusive der Ablöseschicht 11, für die eingesetzte UV-Strahlung durchlässig sein, um eine entsprechende Bestrahlung der Kleberschicht 3 zu ermöglichen, usw.

Nach dem Ausbilden der Verklebung zwischen dem Substrat 1 und der elektrisch leitenden Schicht 2 mittels der Kleberschicht 3 wird gemäß Figur 3 im Querschnitt gesehen die Trägerfolie 10, falls vorhanden inklusive der Ablöseschicht 11, von der elektrisch leitenden Schicht 2 abgezogen. Die Oberfläche des Substrats 1 ist nun mit der elektrisch leitenden Schicht 2 bedeckt und mit dieser mittels der Kleberschicht 3 haftfest verbunden.

In Folge wird eine elektrisch isolierende Resistschicht 4 musterförmig auf der elektrisch leitenden Schicht 2 gebildet, vorzugsweise mittels Druckens. Hierzu eigenen sich insbesondere Druckverfahren wie ein Tiefdruck, Flexodruck, Siebdruck oder Tampondruck. Als Druckmedium zur Bildung der Resistschicht 4 eignet sich beispielsweise die Resist-Zusammensetzung SD 2053 UV-AL der Firma Lackwerke Peters.
Die Resistzusammensetzung wird in einem ersten Bereich der elektrisch leitenden Schicht 2 aufgedruckt, wobei mindestens ein zweiter Bereich 2" der elektrisch leitenden Schicht 2 in Form der zu bildenden mindestens einen musterförmigen Schichtstruktur freigelassen wird und hier weiterhin mindestens zwei streifenförmige dritte Bereiche 2a', 2b' der elektrisch leitenden Schicht 2 mit einer Breite von jeweils 1 mm freigelassen werden. Zwischen den dritten Bereichen 2a', 2b' ist der mindestens eine zweite Bereich 2" angeordnet, wobei die Enden der dritten Bereiche 2a', 2b' in Längsrichtung den mindestens einen zweiten Bereich 2" überragen. Die streifenförmigen dritten Bereiche 2a', 2b' der elektrisch leitenden Schicht 2 sind parallel zueinander und außerdem parallel zu und beabstandet von den Längskanten des Substrats 1 angeordnet.

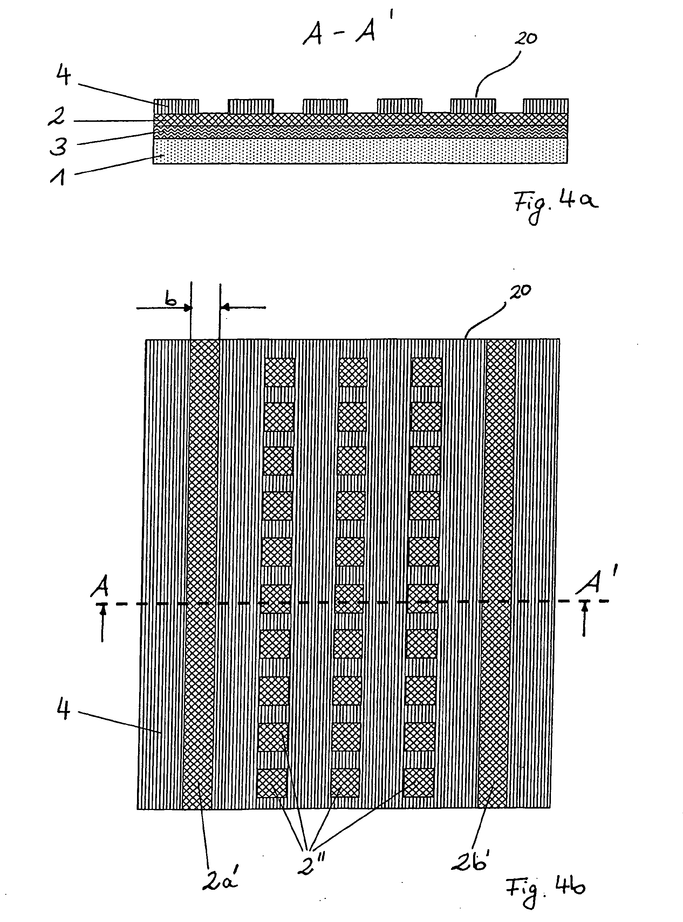

Die sich ergebende Anordnung 20 mit dem Substrat 1, der Kleberschicht 3, der elektrisch leitenden Schicht 2 und der nach dem Auftrag getrockneten und/oder ausgehärteten elektrisch isolierenden Resistschicht 4 zeigt Figur 4a im Querschnitt A - A'. Die Schichtdicke der Resistschicht 4 liegt hierbei im Bereich von 3 µm bis 5 µm.

Die musterförmige Ausgestaltung der gebildeten Resistschicht 4 ergibt sich im Detail aus Figur 4b, in welcher die Resistschicht 4 in der Draufsicht gezeigt ist.

Alternativ kann die Resistzusammensetzung auch vollflächig aufgebracht und anschließend, beispielsweise photolithographisch, bereichsweise wieder entfernt werden, um das gewünschte Muster auszubilden.

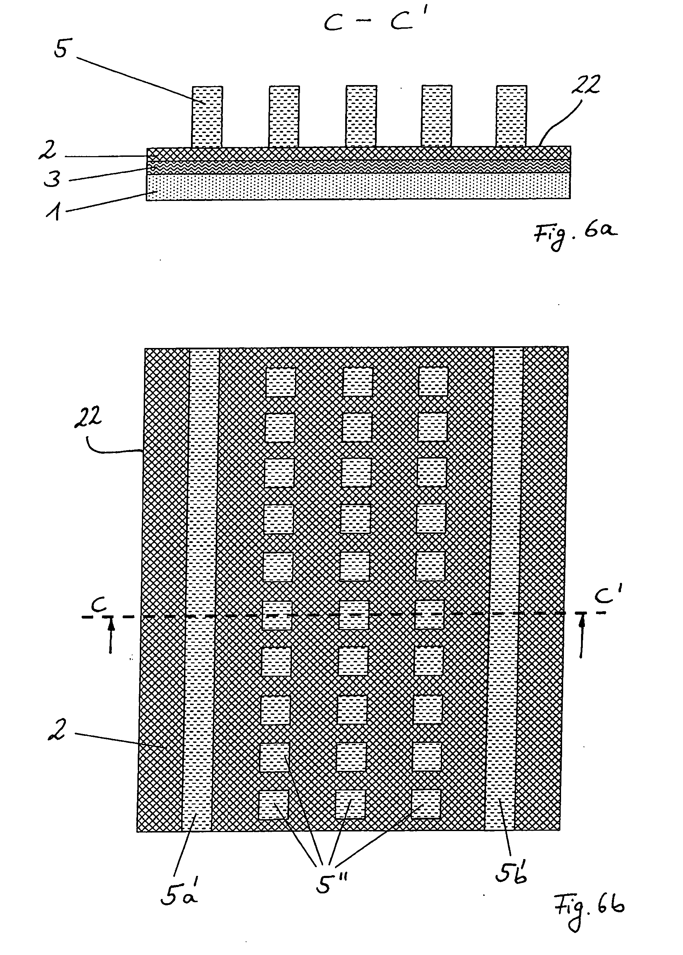

Nun wird die Anordnung 20 gemäß den Figuren 4a und 4b durch mindestens ein galvanisches Bad geführt. Zum Aufbau einer geeigneten Vorrichtung siehe beispielsweise auch die Figuren 1 und 6 der EP 1 562 412 A2.

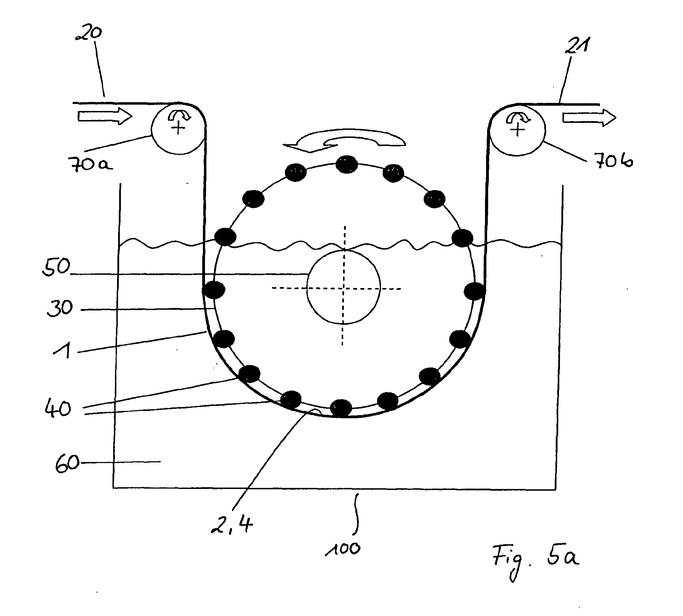

Figur 5a zeigt schematisch im Querschnitt eine Einheit 100 zum Aufgalvanisieren der zweiten Bereiche 2" und der dritten Bereiche 2a', 2b' der elektrisch leitenden Schicht 2 mit einer Metallschicht, wobei die Anordnung 20 je nach gewünschter Dicke der Metallschicht in Folge mehrere solcher Einheiten 100 durchlaufen kann.

Eine Einheit 100 umfasst ein Becken, in dem sich das galvanische Bad 60 befindet. Ein geeignetes Bad, um eine Metallschicht aus Kupfer galvanisch abzuscheiden, weist beispielsweise folgende Zusammensetzung (in Gewichtsteilen) auf:

| | |
|---|---|
| 1000 Teile | H₂O dest. |
| 50 Teile | CuSO₄ |
| 10 Teile | H₂SO₄ (98%ig) |
| 5 Teile | L-Ascorbinsäure |

Um aus einem derartigen Bad eine Metallschicht aus Kupfer von beispielsweise 12 µm Schichtdicke galvanisch abzuscheiden, werden vorzugsweise folgende Parameter gewählt:

| | |
|---|---|
| Abscheidespannung | 12 V |
| Stromdichte | ca. 12 A/dm² |
| Abscheidedauer | ca. 1,5 - 2 min |
| Bad-Temperatur | 50 °C |

Die Dicke der Metallschicht wird umso größer, je höher die Stromdichte, die Abscheidespannung und/oder die Abscheidedauer gewählt werden.

In das galvanische Bad 60 zumindest teilweise eingetaucht befindet sich eine Trommel 30 aus Polypropylen, an deren Umfang Kathodenstäbe 40 aus Edelstahl beabstandet voneinander angeordnet sind, welche parallel zu einer Rotationsachse angeordnet sind, um die die Trommel 30 rotiert (siehe den in Fig. 5a angegebenen Pfeil, der die Rotationsrichtung der Trommel 30 angibt). Die Trommel 30 ist dabei in den Bereichen, die sich zwischen den Kathodenstäben 40 befinden, zumindest bereichsweise für das galvanische Bad 60 durchlässig. Im Bereich der Rotationsachse der Trommel 30 befindet sich ein Anodenblock 50 aus Kupfer. Die Anordnung 20 gemäß den Figuren 4a und 4b wird über eine erste Umlenkrolle 70a in das galvanische Bad 60 und über den Umfang der Trommel 30 geführt, wobei die Anordnung 20 derart zur Trommel 30 ausgerichtet ist, dass die Resistschicht 4, die zweiten Bereiche 2" und die dritten Bereiche 2a', 2b' der elektrisch leitenden Schicht 2 zur Trommel 30 zeigen. Die Kathodenstäbe 40 gelangen im galvanischen Bad 60 zumindest in Kontakt zu den streifenförmigen dritten Bereichen 2a', 2b' der elektrisch leitenden Schicht 2 und kontaktieren diese elektrisch, wobei eine galvanische Abscheidung von Metall nicht nur in den dritten Bereichen 2a', 2b' der elektrisch leitenden Schicht 2, sondern auch in den mit den dritten Bereichen 2a', 2b' elektrisch leitend verbundenen zweiten Bereichen 2" der elektrisch leitenden Schicht 2 erfolgt. Ein direkter elektrischer Kontakt zwischen einem Kathodenstab 40 und den zweiten Bereichen 2" der elektrisch leitenden Schicht 2 ist nicht mehr erforderlich, so dass ein Aufplattieren von zweiten Bereichen 2" mit besonders kleinen Dimensionen, insbesondere mit einer Länge von kleiner als 20 mm, in Transportrichtung des Substrats 1 gesehen, möglich ist.

Damit die elektrisch leitenden streifenförmigen dritten Bereiche 2a', 2b' der elektrisch leitenden Schicht 2 während des Durchlaufs durch das galvanische Bad 60 in jedem Fall in direkten Kontakt zu einem Kathodenstab 40 gelangen und elektrisch kontaktiert werden, ist entweder die Resistschicht 4 entsprechend dünn auszubilden und/oder die Breite der streifenförmigen dritten Bereiche 2a', 2b'entsprechend groß auszubilden.

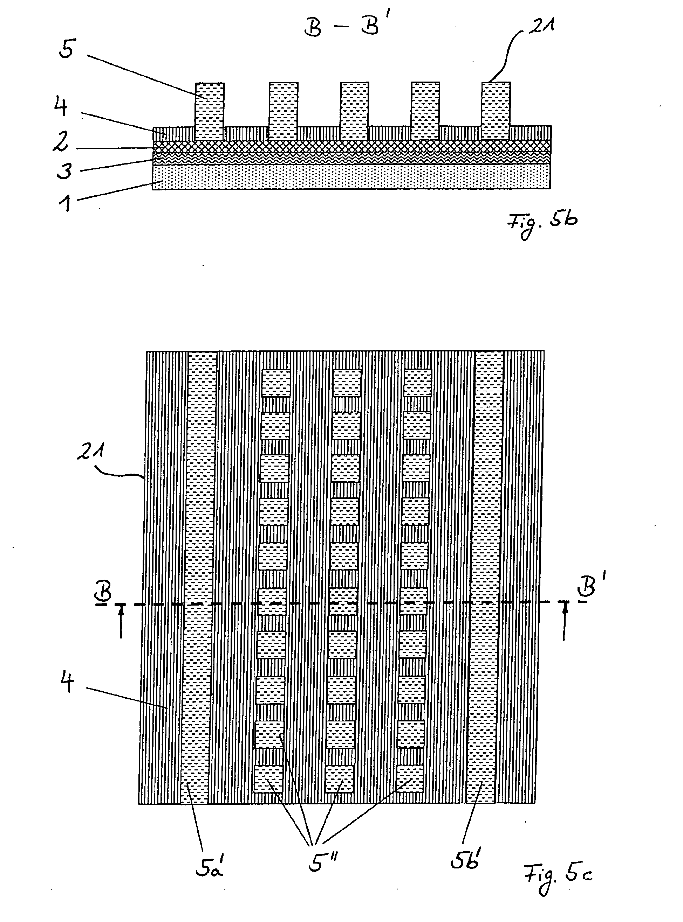

Als Breite b wird dabei die Dimension eines streifenförmigen dritten Bereichs 2a', 2b' betrachtet (siehe Figur 5b), die parallel zu den Kathodenstab-Achsen ausgerichtet ist. Generell gilt dabei, dass bei steigender Schichtdicke der Resistschicht 4 die Breite b eines streifenförmigen dritten Bereiches 2a', 2b' proportional zunehmen soll.

Nach dem Durchlauf durch das galvanische Bad 60 liegt eine Anordnung 21 gemäß Figur 5b vor, die über eine zweite Umlenkrolle 70b weiteren Galvanisiereinheiten oder anderen nachfolgenden Verfahrenseinheiten zugeführt wird.

Figur 5b zeigt im Querschnitt B - B' die Anordnung 21 umfassen das Substrat 1, die Kleberschicht 3, die elektrisch leitende Schicht 2, die Resistschicht 4 und die in den zweiten Bereichen 2" und den dritten Bereichen 2a', 2b' der elektrisch leitenden Schicht 2 galvanisch abgeschiedene Metallschicht 5 aus Kupfer.

Die Metallschicht 5 ist mit einer Schichtdicke im Bereich von 1 µm bis 30 µm ausgebildet, die vorzugsweise höher ist als die der elektrisch leitenden Schicht 2, welche hier eine Schichtdicke von 500 nm aufweist. Die Metallschicht 5 wird insbesondere dann dicker als die elektrisch leitende Schicht 2 ausgeführt, wenn die elektrisch leitende Schicht 2 und die Metallschicht 5 aus gleichem Material gebildet werden.

Figur 5c zeigt die Anordnung gemäß Figur 5b in der Draufsicht. In den zweiten Bereichen 2" der elektrisch leitenden Schicht 2 sind galvanisch darauf abgeschiedene Bereiche 5" der Metallschicht 5 erkennbar, während in den dritten Bereichen 2a', 2b' der elektrisch leitenden Schicht 2 ebenfalls galvanisch darauf abgeschiedene Bereiche 5a', 5b' zu erkennen sind.

Nun erfolgt die Entfernung der musterförmigen Resistschicht 4. Gemäß Figur 6a ist die Anordnung 22 nach Entfernung der Resistschicht 4 im Querschnitt gezeigt. Figur 6b zeigt die Anordnung 22 gemäß Figur 6a, d.h. ohne die Resistschicht 4, in der Draufsicht. Neben den von der Resistschicht befreiten ersten Bereichen der elektrisch leitenden Schicht 2 befinden sich die mit der Metallschicht 5 belegten Bereiche, wobei in den zweiten Bereichen 2" der elektrisch leitenden Schicht 2 (vergleiche Figur 4b) die Bereiche 5" der Metallschicht 5 angeordnet sind und in den streifenförmigen dritten Bereichen 2a', 2b' der elektrisch leitenden Schicht 2 die Bereiche 5a', 5b' der Metallschicht 5 in langgestreckter Form bzw. Streifenform angeordnet sind.

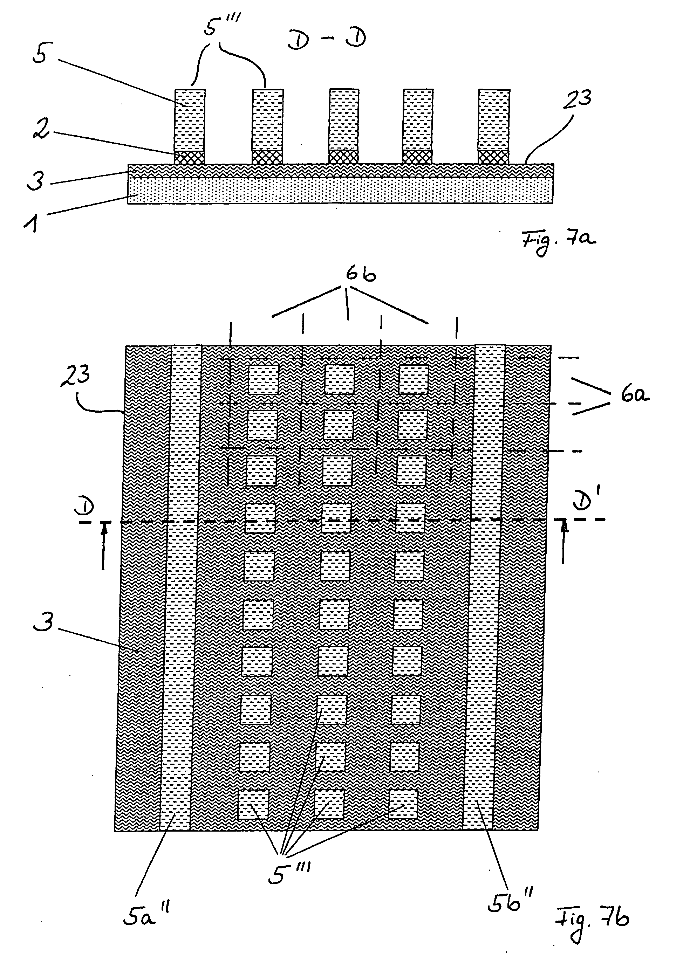

Nun wird gemäß Figur 7a eine Anordnung 23 mit einer Vielzahl an musterförmigen elektrisch leitenden Schichtstrukturen 5"' ausgebildet, wie hier im Querschnitt dargestellt. Dazu wird die Anordnung 22 aus Figur 6a bzw. 6b in eine Ätzlösung getaucht oder mit einer solchen in Kontakt gebracht, die zumindest das Material, aus dem die elektrisch leitende erste Schicht 2 gebildet ist, auflöst. Ist die Metallschicht 5 aus dem gleichen Material gebildet wie die elektrisch leitende Schicht 2, so wird diese durch die Ätzlösung ebenfalls angegriffen und teilweise abgetragen. Damit die elektrisch leitende Schicht 2 im freiliegenden ersten Bereich sicher entfernt werden kann und gleichzeitig die Metallschicht 5 und die davon bedeckten Bereiche 2", 2a', 2b', der elektrisch leitenden Schicht 2 weitgehend bestehen bleiben, wird die Metallschicht 5 vorzugsweise dicker ausgebildet als die elektrisch leitende Schicht 2. Somit wird die elektrisch leitende Schicht 2 im ersten Bereich und weiterhin die Metallschicht 5 jeweils auf ihrer dem Substrat 1 abgewandten Seite solange durch Ätzen abgetragen, bis die elektrisch leitende Schicht 2 im ersten Bereich entfernt ist.

Werden zur Bildung der elektrisch leitenden Schicht 2 und der Metallschicht 5 unterschiedliche Materialien verwendet, und wird eine Ätzlösung eingesetzt, die insbesondere das Material der elektrisch leitenden Schicht 2 angreift, während die Metallschicht 5 nicht oder im wesentlichen nicht angegriffen wird und weiterhin für die Ätzlösung auch nicht durchlässig ist, so kann auch eine Metallschicht 5, die gleich dick oder dünner ist als die elektrisch leitende Schicht 2, verwendet werden. Allerdings ist die Schichtdicke der Metallschicht 5 maßgebend für den elektrischen Widerstand der musterförmigen elektrisch leitenden Schichtstruktur 5"', so dass hier eine natürliche untere Grenze für die Schichtdicke erreicht ist, wenn die gewünschte elektrische Leitfähigkeit der Schichtstruktur 5'"' nicht mehr erreicht wird.

Figur 7b zeigt in der Draufsicht die musterförmige elektrisch leitende Schichtstruktur 5"' auf der elektrisch isolierenden Kleberschicht 3, welche sich auf dem elektrisch isolierenden Substrat 1 befindet.

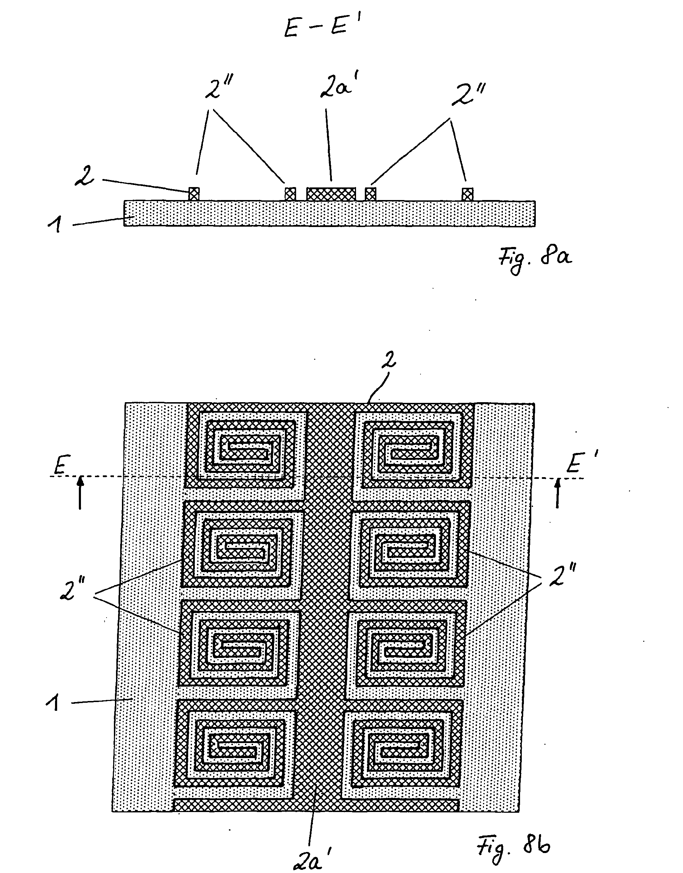

Figur 8a zeigt ein elektrisch isolierendes Substrat 1 aus PC mit einer musterförmig darauf ausgebildeten elektrisch leitenden Schicht 2 im Querschnitt E - E' (vergleiche Figur 8b). Dabei wird die elektrisch leitende Schicht 2 musterförmig auf das Substrat 1 aufgebracht. Dabei weist die elektrisch leitende Schicht mehrere zweite Bereiche 2" in Form der zu bildenden musterförmigen Schichtstrukturen und einen streifenförmigen dritten Bereich 2a' auf.

Figur 8b zeigt die Anordnung aus Figur 8a in der Draufsicht. Es ist erkennbar, dass die elektrisch leitende Schicht 2 zwar musterförmig ausgebildet ist, die einzelnen Bereiche der elektrisch leitenden Schicht 2 aber elektrisch leitend miteinander verbunden sind. Dabei sind acht zweite Bereiche 2" erkennbar, die mit dem streifenförmigen dritten Bereich 2a' elektrisch leitend verbunden sind. Die zweiten Bereiche 2" sind rechts und links neben dem dritten Bereich 2a' angeordnet, wobei der dritte Bereich 2a' in Längsrichtung des Substrats 1 gesehen die zweiten Bereiche 2" miteinander verbindet und überragt. Der streifenförmige dritte Bereich 2a' der elektrisch leitenden Schicht 2 ist beabstandet von den Längskanten des Substrats 1 mittig darauf angeordnet.

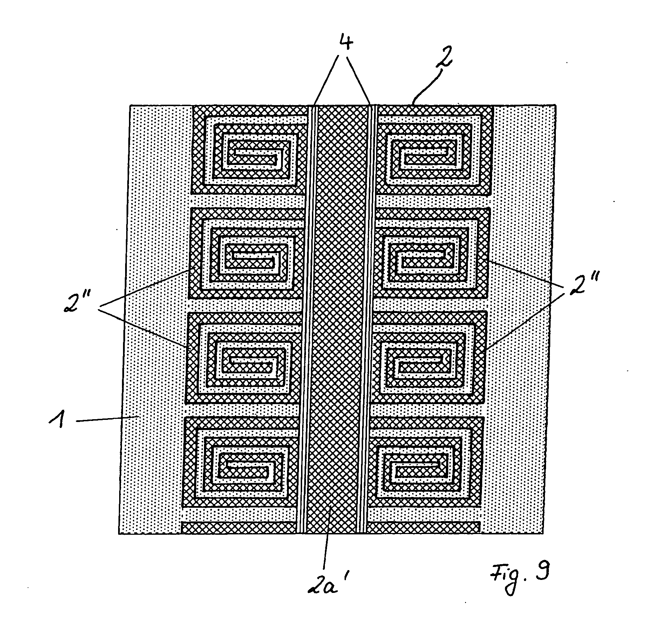

Gemäß Figur 9 wird eine elektrisch isolierende Resistschicht 4 musterförmig auf die elektrisch leitende Schicht 2 aufgebracht, vorzugsweise aufgedruckt. Hierzu eigenen sich insbesondere Druckverfahren wie ein Tiefdruck, Flexodruck, Siebdruck oder Tampondruck. Als Druckmedium zur Bildung der Resistschicht 4 eignet sich auch hier beispielsweise die Resist-Zusammensetzung SD 2053 UV-AL der Firma Lackwerke Peters.

Die Resistzusammensetzung wird in einem ersten Bereich der elektrisch leitenden Schicht 2 aufgedruckt, wobei die zweiten Bereiche 2" der elektrisch leitenden Schicht 2 in Form der zu bildenden musterförmigen Schichtstrukturen freigelassen werden und weiterhin der streifenförmige dritte Bereich 2a' der elektrisch leitenden Schicht 2 mit einer Breite von 1 mm freigelassen wird. Die Schichtdicke der ausgehärteten Resistschicht 4 liegt hierbei im Bereich von 3 µm bis 5 µm.

Nun wird die Anordnung gemäß Figur 9 zum Aufgalvanisieren der zweiten Bereiche 2" und des dritten Bereichs 2a' der elektrisch leitenden Schicht 2 mit einer Metallschicht 5 durch mindestens ein galvanisches Bad geführt (siehe Figur 5a).

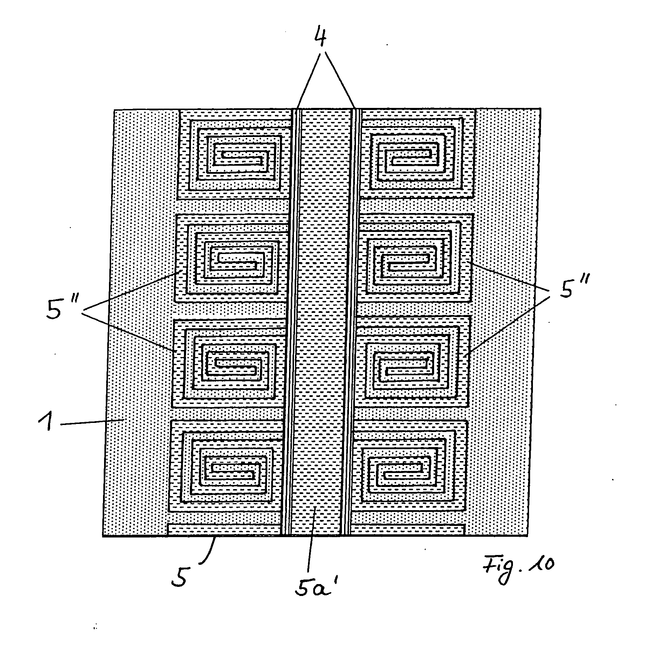

Nach dem Durchlauf durch das galvanische Bad liegt eine Anordnung gemäß Figur 10 vor. Die Metallschicht 5 ist mit einer Schichtdicke im Bereich von 1 µm bis 30 µm ausgebildet, die vorzugsweise höher ist als die der elektrisch leitenden Schicht 2, welche hier eine Schichtdicke von 500 nm aufweist. In den zweiten Bereichen 2" (siehe Figur 9) der elektrisch leitenden Schicht 2 sind galvanisch darauf abgeschiedene Bereiche 5" der Metallschicht 5 erkennbar, während im dritten Bereich 2a' (siehe Figur 9) der elektrisch leitenden Schicht 2 ebenfalls ein galvanisch darauf abgeschiedener Bereich 5a' der Metallschicht 5 zu erkennen sind. Lediglich in den ersten Bereichen der elektrisch leitenden Schicht 2, welche mit der Resistschicht 4 bedeckt sind, erfolgt keine galvanische Metallabscheidung.

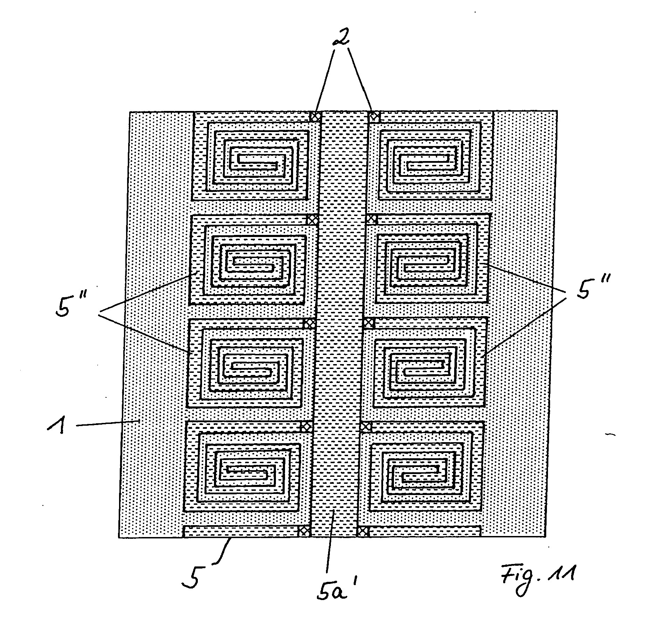

Nun erfolgt die Entfernung der musterförmigen Resistschicht 4. Gemäß Figur 11 ist die Anordnung nach Entfernung der Resistschicht 4 in der Draufsicht gezeigt. Neben den von der Resistschicht 4 befreiten ersten Bereichen, in denen die elektrisch leitende Schicht 2 erkennbar ist, befinden sich die mit der Metallschicht 5 belegten Bereiche, wobei in den zweiten Bereichen 2" der elektrisch leitenden Schicht 2 die Bereiche 5" der Metallschicht 5 angeordnet sind und im streifenförmigen dritten Bereich 2a' der elektrisch leitenden Schicht 2 der Bereich 5a' der Metallschicht 5 in langgestreckter Form bzw. Streifenform angeordnet ist.

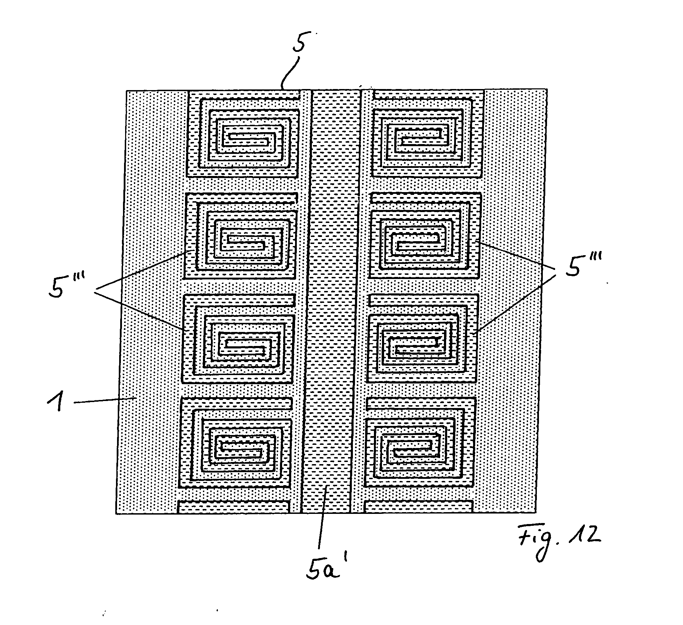

Nun wird die Anordnung gemäß Figur 11 geätzt, damit musterförmige elektrisch leitende Schichtstrukturen 5'" ausgebildet werden, wie in Figur 12 dargestellt. Dazu wird die Anordnung aus Figur 11 in eine Ätzlösung getaucht oder mit einer solchen in Kontakt gebracht, die zumindest das Material, aus dem die elektrisch leitende erste Schicht 2 gebildet ist, auflöst. Ist die Metallschicht 5 aus dem gleichen Material gebildet wie die elektrisch leitende Schicht 2, so wird diese durch die Ätzlösung ebenfalls angegriffen und teilweise abgetragen. Damit die elektrisch leitende Schicht 2 im freiliegenden ersten Bereich sicher entfernt werden kann und gleichzeitig die Metallschicht 5 und die davon bedeckten zweiten und dritten Bereiche 2", 2a' der elektrisch leitenden Schicht 2 weitgehend bestehen bleiben, wird die Metallschicht 5 vorzugsweise dicker ausgebildet als die elektrisch leitende Schicht 2.
So wird die elektrisch leitende Schicht 2 im ersten Bereich und weiterhin die Metallschicht 5 jeweils auf ihrer dem Substrat 1 abgewandten Seite solange durch Ätzen abgetragen, bis die elektrisch leitende Schicht 2 im ersten Bereich entfernt ist.

Die acht gebildeten musterförmigen elektrisch leitenden Schichtstrukturen 5"', welche hier jeweils spiralförmig ausgeformt sind, liegen elektrisch voneinander isoliert und vereinzelt auf dem elektrisch isolierenden Substrat 1 vor.

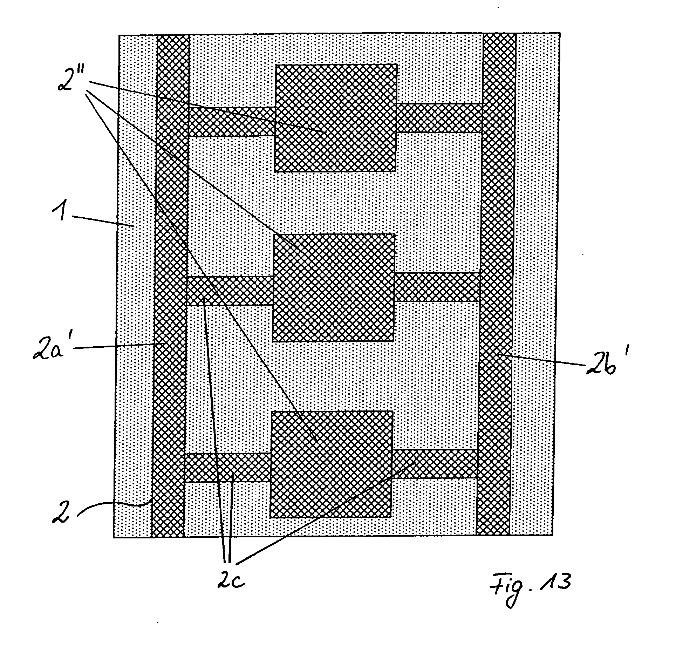

Figur 13 zeigt ein elektrisch isolierendes Substrat 1 aus PC mit einer musterförmig darauf ausgebildeten elektrisch leitenden Schicht 2 in der Draufsicht. Dabei weist die elektrisch leitende Schicht 2 mehrere zweite Bereiche 2" in Form der zu bildenden musterförmigen Schichtstrukturen und zwei streifenförmige dritte Bereiche 2a', 2b' auf. Es ist erkennbar, dass die elektrisch leitende Schicht 2 zwar musterförmig ausgebildet ist, die einzelnen Bereiche der elektrisch leitenden Schicht 2 aber elektrisch leitend miteinander verbunden sind. Dabei sind drei zweite Bereiche 2" vorgesehen, die mit den streifenförmigen dritten Bereichen 2a' elektrisch leitend über Hilfsleiterbahnen 2c, welche Bestandteil der elektrisch leitenden Schicht 2 sind, verbunden sind. Die zweiten Bereiche 2" sind zwischen den beiden dritten Bereichen 2a', 2b' angeordnet, wobei die dritten Bereiche 2a', 2b' in Längsrichtung des Substrats 1 gesehen die zweiten Bereiche 2" miteinander verbinden und überragen. Die streifenförmigen dritten Bereiche 2a', 2b' der elektrisch leitenden Schicht 2 sind beabstandet von den Längskanten des Substrats 1 angeordnet.

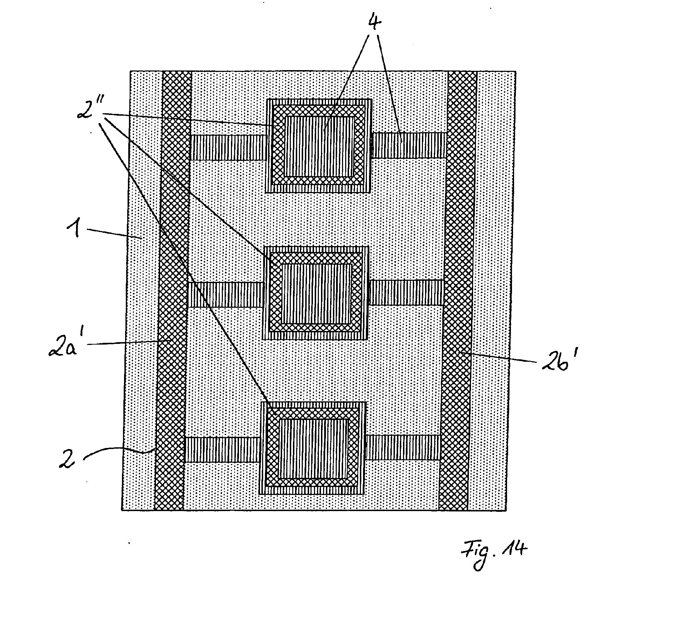

Gemäß Figur 14 wird eine elektrisch isolierende Resistschicht 4 musterförmig auf die elektrisch leitende Schicht 2 aufgebracht, vorzugsweise aufgedruckt. Die Resistzusammensetzung wird in einem ersten Bereich der elektrisch leitenden Schicht 2 aufgedruckt, wobei die zweiten Bereiche 2" der elektrisch leitenden Schicht 2 in Form der zu bildenden musterförmigen Schichtstrukturen freigelassen werden und weiterhin die streifenförmigen dritten Bereiche 2a', 2b' der elektrisch leitenden Schicht 2 mit einer Breite von jeweils 1 mm freigelassen werden. Die Schichtdicke der ausgehärteten Resistschicht 4 liegt hierbei im Bereich von 3 µm bis 5 µm.

Nun wird die Anordnung gemäß der Figur 14 zum Aufgalvanisieren der zweiten Bereiche 2" und der dritten Bereiche 2a', 2b' der elektrisch leitenden Schicht 2 mit einer Metallschicht 5 durch mindestens ein galvanisches Bad geführt (siehe Figur 5a).

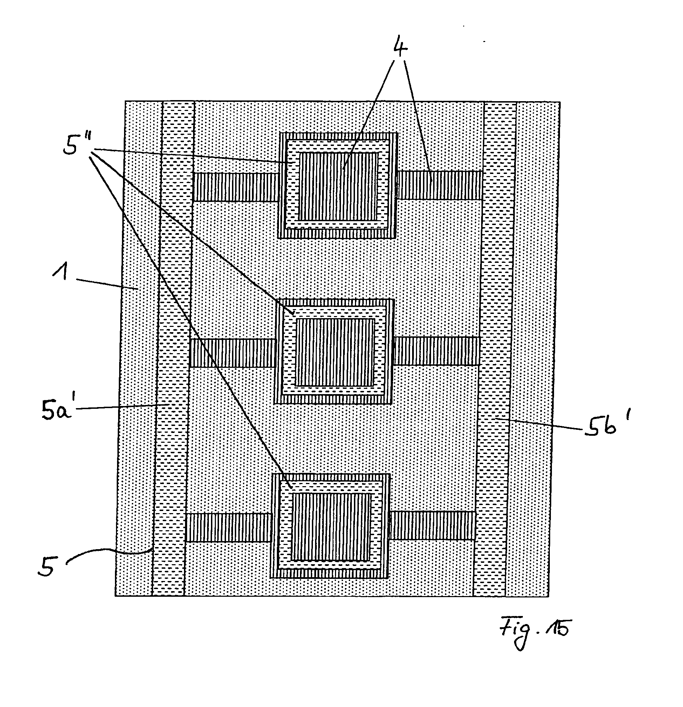

Nach dem Durchlauf durch das galvanische Bad liegt eine Anordnung gemäß Figur 15 vor. Die Metallschicht 5 ist mit einer Schichtdicke im Bereich von 1 µm bis 30 µm ausgebildet, die vorzugsweise höher ist als die der elektrisch leitenden Schicht 2, welche hier eine Schichtdicke von 500 nm aufweist. In den zweiten Bereichen 2" (siehe Figur 14) der elektrisch leitenden Schicht 2 sind galvanisch darauf abgeschiedene Bereiche 5" der Metallschicht 5 erkennbar, während in den dritten Bereichen 2a', 2b' (siehe Figur 14) der elektrisch leitenden Schicht 2 ebenfalls galvanisch darauf abgeschiedene Bereiche 5a', 5b' der Metallschicht 5 zu erkennen sind. Lediglich in den ersten Bereichen der elektrisch leitenden Schicht 2, welche mit der Resistschicht 4 bedeckt sind, erfolgt keine galvanische Metallabscheidung.

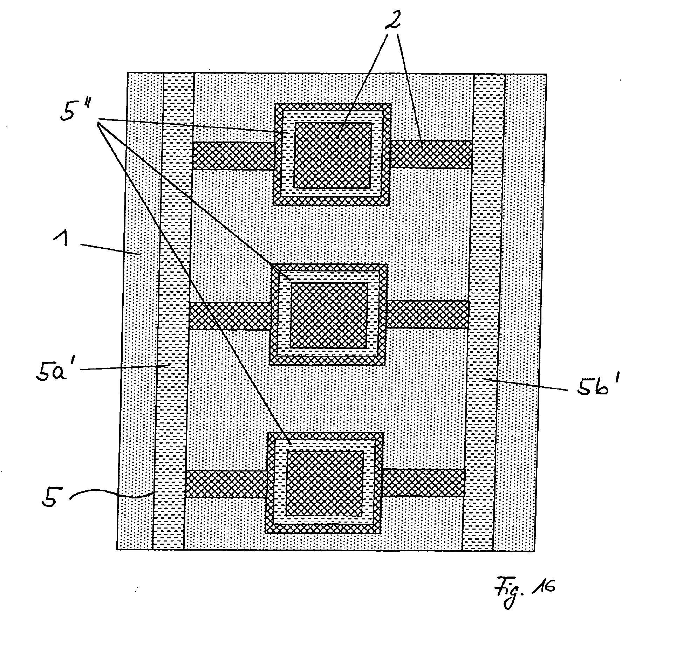

Nun erfolgt die Entfernung der musterförmigen Resistschicht 4. Gemäß Figur 16 ist die Anordnung nach Entfernung der Resistschicht 4 in der Draufsicht gezeigt. Neben den von der Resistschicht 4 befreiten ersten Bereichen, in denen nun wieder die elektrisch leitende Schicht 2 erkennbar ist, befinden sich die mit der Metallschicht 5 belegten Bereiche, wobei in den zweiten Bereichen 2" der elektrisch leitenden Schicht 2 die Bereiche 5" der Metallschicht 5 angeordnet sind und in den streifenförmigen dritten Bereichen 2a', 2b' der elektrisch leitenden Schicht 2 die Bereiche 5a', 5b' der Metallschicht 5 in langgestreckter Form bzw. Streifenform angeordnet sind.

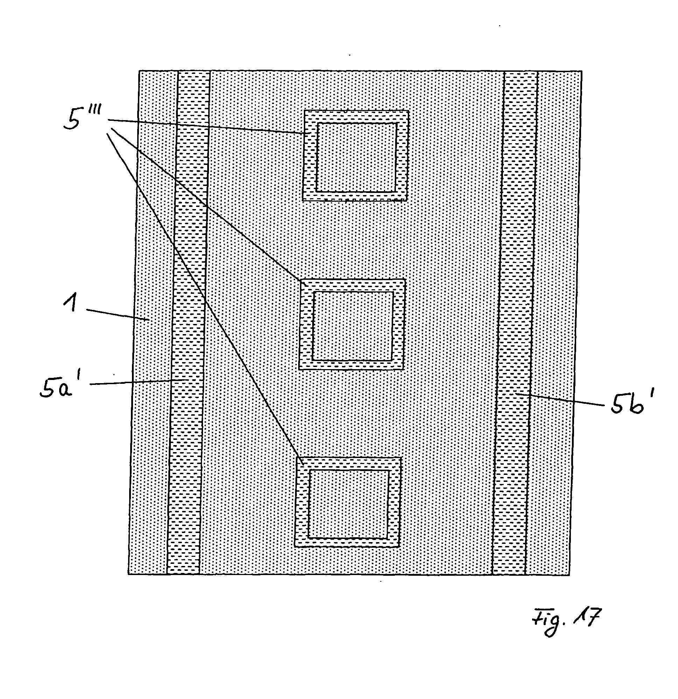

Nun wird die Anordnung gemäß Figur 16 geätzt, damit musterförmige elektrisch leitende Schichtstrukturen 5'" ausgebildet werden, wie in Figur 17 dargestellt. Dazu wird die Anordnung aus Figur 16 in eine Ätzlösung getaucht oder mit einer solchen in Kontakt gebracht, die zumindest das Material, aus dem die elektrisch leitende erste Schicht 2 gebildet ist, auflöst. Ist die Metallschicht 5 aus dem gleichen Material gebildet wie die elektrisch leitende Schicht 2, so wird diese in jedem Fall durch die Ätzlösung ebenfalls angegriffen und teilweise abgetragen. Damit die elektrisch leitende Schicht 2 im freiliegenden ersten Bereich sicher entfernt werden kann und gleichzeitig die Metallschicht 5 und die davon bedeckten Bereiche 2", 2a', 2b', der elektrisch leitenden Schicht 2 weitgehend bestehen bleiben, ist die Metallschicht 5 vorzugsweise dicker ausgebildet als die elektrisch leitende Schicht 2.

So werden die elektrisch leitende Schicht 2 im ersten Bereich und weiterhin die Metallschicht 5 jeweils auf ihrer dem Substrat 1 abgewandten Seite solange durch Ätzen abgetragen, bis die elektrisch leitende Schicht 2 im ersten Bereich entfernt ist.

Die drei gebildeten musterförmigen elektrisch leitenden Schichtstrukturen 5"', welche hier jeweils rahmenförmig ausgeformt sind, liegen elektrisch voneinander isoliert und vereinzelt auf dem elektrisch isolierenden Substrat 1 vor.

Die Figuren 1a bis 17 zeigen die Ausgestaltung der musterförmigen elektrisch leitenden Schichtstruktur lediglich schematisch. Dem Fachmann ist dabei aber ohne weiteres verständlich, dass hier nicht nur einfach geformte Schichtstrukturen, sondern diverse Formen und filigrane Muster an Schichtstrukturen, beispielsweise komplizierte Antennen, mäanderförmige Leiterbahnen und dergleichen, mit äußerst geringen Dimensionen, insbesondere in Transportrichtung des Substrats 1 gesehen, ausgebildet werden können.

Weiterhin ist die gebildete Schichtstruktur nicht darauf beschränkt, dass die Metallschicht aus einem Material gebildet ist. Vielmehr können in nacheinander geschalteten Galvanisiereinheiten unterschiedliche Materialien abgeschieden werden und eine Schichtstruktur somit eine mehrschichtige Metallschicht umfassen, die durch Einzelschichten aus unterschiedlichen Metallen aufgebaut ist.

## Patentansprüche

1. Verfahren zur Herstellung mindestens einer musterförmig ausgebildeten, elektrisch leitenden Schichtstruktur (5"') auf einem elektrisch isolierenden Substrat (1), folgende Schritte umfassend:
Aufbringen einer elektrisch leitenden Schicht (2) auf mindestens einer Oberfläche des Substrats (1);
Ausbilden einer elektrisch isolierenden Resistschicht (4) in einem ersten Bereich der elektrisch leitenden Schicht (2), wobei mindestens ein zweiter Bereich (2") der elektrisch leitenden Schicht (2) in Form der zu bildenden mindestens einen musterförmigen Schichtstruktur (5"') freigelassen wird und weiterhin mindestens ein streifenförmiger dritter Bereich (2a', 2b') der elektrisch leitenden Schicht (2) freigelassen wird, wobei die ersten, zweiten und dritten Bereiche der elektrisch leitenden Schicht (2) elektrisch leitend miteinander verbunden sind und der mindestens eine dritte Bereich (2a', 2b') Enden aufweist, die in Längsrichtung des mindestens einen dritten Bereichs (2a', 2b') gesehen den mindestens einen zweiten Bereich (2") zumindest einseitig überragen;
Herstellen eines direkten Kontakts zwischen einem Kathodenstab (40) und dem mindestens einen streifenförmigen dritten Bereich (2a', 2b') der elektrisch leitenden Schicht (2) in einem galvanischen Bad (60), mit Führen des als flexible Folienbahn ausgebildeten Substrats (1) um einen Abschnitt des Umfangs einer um eine Rotationsachse rotierenden Trommel (30), die sich zumindest teilweise in das galvanische Bad (60) eingetaucht befindet und an deren Umfang im wesentlichen parallel zu der Rotationsachse angeordnete Kathodenstäbe (40) beabstandet voneinander angeordnet sind, wobei die Oberfläche des Substrats, auf der die elektrisch leitende Schicht (2) aufgebracht ist, zu der Trommel (30) hin orientiert ist;
Galvanisches Abscheiden einer Metallschicht (5) in dem mindestens einen zweiten Bereich (2") und dem mindestens einen dritten Bereich (2a', 2b') der elektrisch leitenden Schicht (2);
Entfernen der Resistschicht (4);
Ausbilden der mindestens einen musterförmigen Schichtstruktur (5"'), indem die elektrisch leitende Schicht (2) im ersten Bereich und weiterhin die Metallschicht (5) jeweils auf ihrer dem Substrat (1) abgewandten Seite solange durch Ätzen abgetragen werden, bis die elektrisch leitende Schicht (2) im ersten Bereich entfernt ist.

2. Verfahren nach Anspruch 1,
wobei der mindestens eine dritte Bereich (2a', 2b') eine Streifenlänge von mindestens 20 mm aufweist.

3. Verfahren nach einem der Ansprüche 1 und 2,
wobei der mindestens eine streifenförmige dritte Bereich (2a', 2b') derart ausgebildet wird, dass dieser sich über eine Länge des Substrats (1) erstreckt.

4. Verfahren nach einem der Ansprüche 1 bis 3,
wobei der mindestens eine streifenförmige dritte Bereich (2a', 2b') derart ausgebildet wird, dass dieser sich lediglich über einen Abschnitt des Substrats (1) erstreckt.

5. Verfahren nach Anspruch 4,
wobei eine Vielzahl von dritten Bereichen (2a', 2b') in Längsrichtung des Substrats (1) nacheinander folgend angeordnet werden.

6. Verfahren nach Anspruch 4 oder Anspruch 5,
wobei mindestens zwei streifenförmige dritte Bereiche (2a', 2b') gebildet werden, deren Enden auf gleicher Höhe oder versetzt zueinander auf dem Substrat (1) angeordnet werden.

7. Verfahren nach einem der Ansprüche 1 bis 6,
wobei ein langgestrecktes flexibles Substrat (1) eingesetzt wird.

8. Verfahren nach Anspruch 7,
wobei das Verfahren durchgeführt wird, während das Substrat (1) von Rolle zu Rolle transportiert wird.

9. Verfahren nach einem der Ansprüche 1 bis 8,
wobei die elektrisch leitende Schicht (2) auf die Oberfläche des Substrats (1) durch Aufdampfen, Sputtern, chemische Dampfphasenabscheidung, Prägen oder Laminieren aufgebracht wird.

10. Verfahren nach einem der Ansprüche 1 bis 9,
wobei die elektrisch leitende Schicht (2) lediglich bereichsweise auf die Oberfläche des Substrats (1) aufgebracht wird.

11. Verfahren nach einem der Ansprüche 1 bis 10,
wobei die Resistschicht (4) musterförmig auf das Substrat (1) aufgedruckt oder aufgeprägt wird.

12. Verfahren nach einem der Ansprüche 1 bis 10,
wobei die Resistschicht (4) vollflächig auf das Substrat (1) aufgebracht und anschließend strukturiert wird, indem sie in dem mindestens einen zweiten Bereich (2") und den mindestens zwei streifenförmigen dritten Bereichen (2a', 2b') entfernt wird.

## Claims

1. Method for producing at least one electrically conductive layer structure (5"') formed in patterned fashion on an electrically insulating substrate (1), comprising the following steps:
applying an electrically conductive layer (2) on at least one surface of the substrate (1);
forming an electrically insulating resist layer (4) in a first region of the electrically conductive layer (2), wherein at least one second region (2") of the electrically conductive layer (2) in the form of the at least one patterned layer structure (5"') to be formed is left free and furthermore at least one strip-shaped third region (2a', 2b') of the electrically conductive layer (2) is left free, wherein the first, second and third regions of the electrically conductive layer (2) are electrically conductively connected to one another and the at least one third region (2a', 2b') has ends which, as seen in the longitudinal direction of the at least one third region (2a', 2b'), project beyond the at least one second region (2") at least on one side;
producing a direct contact between a cathode rod (40) and the at least one strip-shaped third region (2a', 2b') of the electrically conductive layer (2) in an electroplating bath (60), with the substrate (1) embedded as a flexible film when being guided around a section of the circumference of a drum (30) which rotates about a rotation axis and which is situated in a manner at least partly immersed in the electroplating bath (60) and on the circumference of which cathode rods (40) arranged substantially parallel to the rotation axis are arranged at a distance from one another, wherein the surface of the substrate on which the electrically conductive layer (2) is applied is oriented towards the drum (30);
electrodepositing a metal layer (5) in the at least one second region (2") and the at least one third region (2a', 2b') of the electrically conductive layer (2);
removing the resist layer (4);
forming the at least one patterned layer structure (5"') by eroding the electrically conductive layer (2) in the first region and furthermore the metal layer (5) in each case on the side facing away from the substrate (1) by means of etching until the electrically conductive layer (2) has been removed in the first region.

2. Method according to Claim 1,
wherein the at least one third region (2a', 2b') has a strip length of at least 20 mm.

3. Method according to either of Claims 1 and 2,
wherein the at least one strip-shaped third region (2a', 2b') is formed in such a way that it extends over a length of the substrate (1).

4. Method according to any of Claims 1 to 3,
wherein at least one strip-shaped third region (2a', 2b') is formed in such a way that it extends only over a section of the substrate (1).

5. Method according to Claim 4,
wherein a multiplicity of third regions (2a', 2b') are arranged successively in the longitudinal direction of the substrate (1).

6. Method according to Claim 4 or Claim 5,
wherein at least two strip-shaped third regions (2a', 2b') are formed, the ends of which are arranged at the same level or offset with respect to one another on the substrate (1).

7. Method according to any of Claims 1 to 6,
wherein an elongated flexible substrate (1) is used.

8. Method according to Claim 7,
wherein the method is carried out while the substrate (1) is transported from roll to roll.

9. Method according to any of Claims 1 to 8,
wherein the electrically conductive layer (2) is applied to the surface of the substrate (1) by vapour deposition, sputtering, chemical vapour phase deposition, embossing or lamination.

10. Method according to any of Claims 1 to 9,
wherein the electrically conductive layer (2) is applied to the surface of the substrate (1) only in regions.

11. Method according to any of Claims 1 to 10,
wherein the resist layer (4) is printed or embossed onto the substrate (1) in patterned fashion.

12. Method according to any of Claims 1 to 10,
wherein the resist layer (4) is applied to the substrate (1) over the whole area and is subsequently patterned by being removed in the at least one second region (2") and the at least two strip-shaped third regions (2a', 2b').

## Revendications

1. Procédé de fabrication d'au moins une structure de couches électriquement conductrices (5"') réalisée sous forme de motif sur un substrat diélectrique (1), comprenant les étapes suivantes consistant à :
appliquer une couche (2) électriquement conductrice sur au moins une surface du substrat (1) ;
réaliser une couche de résist (4) diélectrique dans une première zone de la couche (2) électriquement conductrice, dans lequel au moins une deuxième zone (2") de la couche (2) électriquement conductrice est laissée libre sous la forme de la structure de couche (5'") en forme de motif à former, et de plus, au moins une troisième zone (2a', 2b') en forme de ruban de la couche (2) électriquement conductrice est laissée libre, dans lequel les première, deuxième et troisième zones de la couche (2) électriquement conductrice sont reliées ensemble de manière électriquement conductrice et ladite au moins une troisième zone (2a', 2b') présente des extrémités qui, vues dans la direction longitudinale de ladite au moins une troisième zone (2a', 2b') dépassent de ladite au moins une deuxième zone (2") au moins d'un côté ;
établir un contact direct entre une tige de cathode (40) et ladite au moins une troisième zone (2a', 2b') en forme de ruban de la couche (2) électriquement conductrice dans un bain électrolytique (60), tout en amenant le substrat (1) réalisé sous la forme de bande de film flexible autour d'un secteur de la circonférence d'un tambour (30) tournant autour d'un axe de rotation et au moins partiellement plongé dans le bain électrolytique (60), et sur la circonférence duquel des tiges de cathode (40) disposées substantiellement en parallèle à l'axe de rotation sont disposées de manière espacée les unes des autres, dans lequel la surface du substrat à laquelle est appliquée la couche (2) électriquement conductrice est orientée vers le tambour (30) ;
déposer par électrolyse une couche de métal (5) dans ladite au moins une deuxième zone (2") et ladite au moins une troisième zone (2a', 2b') de la couche (2) électriquement conductrice ;
retirer la couche de résist (4) ;
réaliser ladite au moins une structure de couches (5'") sous forme de motif en ce que, respectivement sur leur côté détourné du substrat (1), la couche (2) électriquement conductrice est enlevée dans la première zone, et de plus, la couche métallique (5) est enlevée par gravure jusqu'à ce que la couche (2) électriquement conductrice ait été retirée dans la première zone.

2. Procédé selon la revendication 1, sachant que ladite au moins une troisième zone (2a', 2b') présente une longueur de ruban d'au moins 20 mm.

3. Procédé selon l'une quelconque des revendications 1 et 2, sachant que ladite au moins une troisième zone (2a', 2b') en forme de ruban est réalisée de telle sorte qu'elle s'étend sur une longueur du substrat (1).

4. Procédé selon l'une quelconque des revendications 1 à 3, sachant que ladite au moins une troisième zone (2a', 2b') en forme de ruban est réalisée de telle sorte qu'elle s'étend uniquement sur un secteur du substrat (1).

5. Procédé selon la revendication 4, sachant qu'une pluralité de troisièmes zones (2a', 2b') est disposée dans une direction longitudinale du substrat (1) les unes après les autres.

6. Procédé selon la revendication 4 ou 5, sachant qu'au moins deux troisièmes zones (2a', 2b') en forme de ruban sont formées dont les extrémités sont disposées sur le substrat (1) au même niveau ou de manière décalée les unes par rapport aux autres.

7. Procédé selon l'une quelconque des revendications 1 à 6, sachant qu'un substrat (1) flexible allongé est mis en oeuvre.

8. Procédé selon la revendication 7, sachant que le procédé est effectué pendant que le substrat (1) est transporté d'un rouleau à l'autre.

9. Procédé selon l'une quelconque des revendications 1 à 8, sachant que la couche (2) électriquement conductrice est appliquée sur la surface du substrat (1) par métallisation sous vide, pulvérisation cathodique, dépôt chimique en phase vapeur, estampage ou contrecollage.

10. Procédé selon l'une quelconque des revendications 1 à 9, sachant que la couche (2) électriquement conductrice est appliquée seulement par endroits sur la surface du substrat (1).

11. Procédé selon l'une quelconque des revendications 1 à 10, sachant que la couche de résist (4) est imprimée ou estampée sur le substrat (1) sous forme de motif.

12. Procédé selon l'une quelconque des revendications 1 à 10, sachant que la couche de résist (4) est appliquée sur toute la surface du substrat (1) et ensuite texturée en étant retirée dans ladite au moins une deuxième zone (2") et lesdites au moins deux troisièmes zones (2a', 2b') en forme de ruban.
